# EUROPÄISCHE PATENTSCHRIFT

(11) **EP 2 999 766 B1**
(45) Veröffentlichungstag und Bekanntmachung des Hinweises auf die Patenterteilung: **15.11.2017**
(21) Anmeldenummer: 14724389.3
(22) Anmeldetag: 08.05.2014
(51) Int. Cl.: C09K 11/06, H05B 33/14

(54) **HERSTELLUNG ORGANISCH PHOSPHORESZENTER SCHICHTEN UNTER ZUSATZ SCHWERER HAUPTGRUPPENMETALLKOMPLEXE**
PRODUCTION OF ORGANIC PHOSPHORESCENT LAYERS WITH ADDITION OF HEAVY MAIN GROUP METAL COMPLEXES
PRODUCTION DE COUCHES PHOSPHORESCENTES ORGANIQUES PAR AJOUT DE COMPLEXES MÉTALLIQUES LOURDS DU GROUPE PRINCIPAL

(30) Priorität: 05.08.2013 DE 102013215342
(43) Veröffentlichungstag der Anmeldung: 30.03.2016
(73) Patentinhaber: Siemens Aktiengesellschaft, 80333 München (DE)
(72) Erfinder: KRESTEL, Ana-Maria, 91052 Erlangen (DE); SCHMID, Günter, 91334 Hemhofen (DE); KESSLER, Florian, 91315 Höchstadt an der Aisch (DE); MALTENBERGER, Anna, 91359 Leutenbach (DE); TAROATA, Dan, 91054 Erlangen (DE)
(86) Internationale Anmeldenummer: PCT/EP2014/059463
(87) Internationale Veröffentlichungsnummer: WO 2015/018539

(56) Entgegenhaltungen:
- DE-A1- 10 360 681
- JP-A- 2002 110 357
- US-A1- 2005 129 978
- US-A1- 2012 045 862
- RAUF M A ET AL: "Spectrophotometric studies of ternary complexes of lead and bismuth with o-phenanthroline and eosin", DYES AND PIGMENTS, ELSEVIER APPLIED SCIENCE PUBLISHERS. BARKING, GB, Bd. 52, Nr. 3, 24. Dezember 2001 (2001-12-24), Seiten 183-189, XP004335191, ISSN: 0143-7208, DOI: 10.1016/S0143-7208(01)00098-5
- ZHIWEI LIU ET AL: "A Codeposition Route to CuI-Pyridine Coordination Complexes for Organic Light-Emitting Diodes", JOURNAL OF THE AMERICAN CHEMICAL SOCIETY, Bd. 133, Nr. 11, 2. März 2011 (2011-03-02) , Seiten 3700-3703, XP055009605, ISSN: 0002-7863, DOI: 10.1021/ja1065653

## Beschreibung

Die vorliegende Erfindung betrifft ein Verfahren zur Herstellung organisch elektrischer Schichten aufweisend bei Raumtemperatur phosphoreszente organische Emitter, dadurch gekennzeichnet, dass organisch fluoreszente Emitter F zusammen mit Metallkomplexen enthaltend organische Komplexliganden L und mindestens ein schweres Hauptgruppenmetall M ausgewählt aus der Gruppe umfassend In, Tl, Sn, Pb, Sb und Bi, gemeinsam innerhalb einer Schicht abgeschieden werden und das schwere Hauptgruppenmetall M seine Koordinationssphäre unter Aufnahme des organisch fluoreszenten Emitters F ändert.

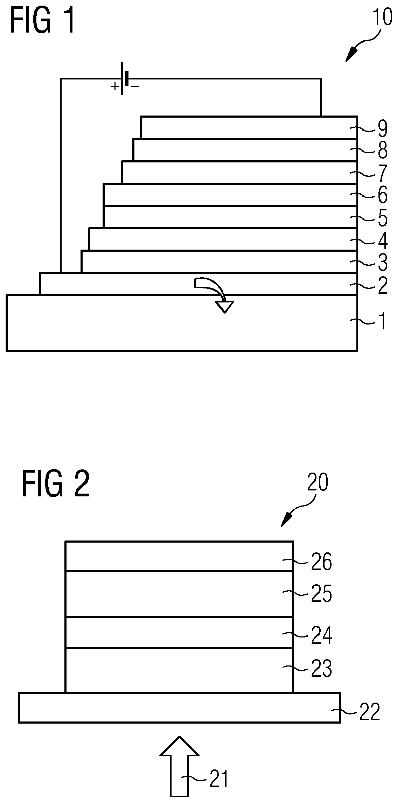

Prinzipielle Methoden zur Umwandlung von Licht in elektrischen Strom (und umgekehrt) mittels organischer Elektronik sind seit einigen Jahrzehnten bekannt. Technisch durchgesetzt, und derzeit an der Grenze zur Massenmarktreife, haben sich Mehrschichtaufbauten, wie sie zum Beispiel in Figur 1 für eine organische Licht emittierenden Diode (OLED) oder in Figur II für eine organische Solarzelle schematisch dargestellt sind. Obwohl die Effizienz dieser Komponenten gerade in den letzten Jahren durch den Einsatz optimierter organischer Verbindungsklassen eine deutliche Leistungssteigerung erfuhr, ergeben sich weiterhin vielversprechende Ansatzpunkte noch höhere Quantenausbeuten und damit noch höhere Wirkungsgrade bei gesenkten Materialkosten bereitzustellen.

Einer dieser Ansatzpunkte liegt in der Verwendung phosphoreszenter Emitter, sogenannter Triplett-Emitter, welche zum Beispiel in PHOLEDs (phosphorescent organic light-emitting devices) Verwendung finden. In Anbetracht der geltenden Quantenstatistik sind diese, zumindest theoretisch, in der Lage, einen internen Quanten-Wirkungsgrad von 100% zu erreichen. Dies im Gegensatz zu Dioden mit rein fluoreszenten Emittern, welche aufgrund der Quantenstatistik der injizierten Ladungsträger eine maximale interne Quantenausbeute von nur 25 % aufweisen.

Betrachtet man alleine die interne Quantenausbeute, so sind also Bauteile der organischen Elektronik, welche eine auf Phosphoreszenz basierende Umwandlung von Strom in Licht (und umgekehrt) nutzen (Triplett-Emitter/Emission), eher geeignet eine hohe Lumineszenz (cd/m²) bzw. Effizienz (cd/A, lm/W) bereitzustellen. Im Bereich der Verbindungen, welche zu Triplett-Emission befähigt sind, gibt es allerdings mehrere Randbedingungen zu beachten. Zwar tritt Phosphoreszenz auch in Verbindungen der Elemente der vierten und fünften Periode des Periodensystems auf, durchgesetzt haben sich in oben genannten Anwendungen jedoch die Komplexe der Metalle der 6. Periode. Je nach Lage der Elemente in dieser Periode ist dabei der Ursprung der Phosphoreszenz innerhalb der Orbitalstruktur der Komplexe unterschiedlich gewichtet.

Bei den Lanthanoiden ist sowohl das HOMO (Highest Occupied Molecular Orbital) als auch das LUMO (Lowest Unoccupied Molecular Orbital) vorwiegend metallzentriert, d.h. der Anteil der Liganden-Orbitale ist relativ schwach ausgeprägt. Dies führt dazu, dass die Emissionswellenlänge (Farbe) der Emitter fast ausschließlich durch die Bandstruktur des Metalls festgelegt ist (Beispiele Europium = rot, Terbium = grün). Aufgrund der starken Abschirmung der f-Elektronen dieser Metalle vermögen an das Metall gekoppelte Liganden die Energien der fⁿ-Konfiguration der Metalle nur um circa 100 cm⁻¹ aufzuspalten, sodass sich die Spektroskopie durch ihr Ligandenfeld der d-Ionen von derjenigen der f-Ionen erheblich unterscheidet. Bei Ionen der Lanthaniden resultiert die Farbe aus Übergängen von f- in unbesetzte s-, p- und d-Orbitale.

Geht man entlang der Periode zu den Elementen Osmium, Iridium, Platin und Gold, so spalten Ligandenfelder die Metallorbitale um einen Faktor 10 - 100mal mehr auf als im Falle der Lanthanoiden. Damit lässt sich durch Variation der Liganden praktisch das gesamte sichtbare Wellenlängenspektrum mit diesen Elementen darstellen. Durch die starke Kopplung des Bahndrehimpulses des Metallatoms mit dem Spindrehimpuls der Elektronen wird in den Emittern Phosphoreszenz erhalten. Das HOMO ist dabei meist metallzentriert, während das LUMO meist ligandzentriert ist. Die strahlenden Übergänge werden daher als Metall-Ligand-Charge-Transferübergänge (MLCT) bezeichnet.

Sowohl OLEDs als auch OLEECs (light-emitting organic electrochemical cell) nutzen derzeit fast ausschließlich Iridium-Komplexe als Emitter. Im Falle der OLEDs sind die Emitter-Komplexe ungeladen, im Falle der OLEECs werden ionische d.h. geladene Emitter-Komplexe genutzt. Die Verwendung von Iridium in diesen Bauteilen hat jedoch einen gravierenden Nachteil. Die Jahresproduktion von Iridium liegt weit unter 10 t (3t in 2000). Dies führt dazu, dass die Material-Kosten einen signifikanten Beitrag zu den Herstellkosten organisch elektrischer Bauteile leisten. Hinzu kommt, dass Iridium-Emitter nicht in der Lage sind, effizient das gesamte Spektrum des sichtbaren Lichts abzubilden. So sind beispielsweise stabile blaue Iridium-Emitter eher selten, welches einer flexiblen Verwendung dieser Materialien in OLED oder OLECC Anwendungen entgegensteht.

In der neueren Literatur finden sich hingegen einige Ansätze, welche ein "Triplett-Harvesting" auch mit nicht auf Iridium basierenden Emittern vorschlagen. So verweisen zum Beispiel Omary et al. in "Enhancement of the Phosphorescence of Organic Luminophores upon interaction with a Mercury Trifunctional Lewis Acid" (Mohammad A. Omary, Refaie M. Kassab, Mason R. Haneline, O. Elbjeirami, and Francois P. Gabbai, Inorg. Chem. 2003, 42, 2176-2178) auf die Möglichkeit zur Erreichung einer ausreichenden Phosphoreszenz rein organischer Emitter durch den Einsatz von Quecksilber. Bedingt durch den Schweratomeffekt des Quecksilbers in einer Matrix aus organischen Liganden wird ein Singulett-Triplett- /Triplett-Singulett-Übergang der angeregten Elektronen der organischen Matrix quantenmechanisch ermöglicht (ISC, inter system crossing), welches in einer deutlichen Verringerung der Lebensdauer der angeregten elektronischen (Triplett) Zustände resultiert und eine unerwünschte Sättigung der Besetzung dieser Zustände vermeidet. Ursächlich für diesen Mechanismus ist die Spin-Bahnkopplung des Quecksilber-Schweratoms mit den angeregten Elektronen der organischen Matrix. Nachteilig hingegen ist, dass der Einsatz von Quecksilber aufgrund von toxischen und umweltpolitischen Aspekten problematisch ist.

Eine Möglichkeit eine hinreichende Quantenausbeute auf Basis rein organischer Phosphoreszenz-Emitter zu erhalten wird zum Beispiel durch Bolton et al. in NATURE CHEMISTRY, 2011, 1-6 beschrieben ("Activating efficient phosphorescence from purely organic materials by crystal design", Onas Bolton, Kangwon Lee, Hyong-Jun Kim, Kevin Y. Lin and Jinsang Kim. NATURE CHEMISTRY, 2011, 1-6). An dieser Stelle wird vorgestellt, dass der Einbau schwerer Halogenide in einen Kristall aus einer organischen Matrix zu hohen Quantenausbeuten durch phosphoreszierende organische Emitter führt. Nachteilig an dieser Lösung ist hingegen, dass für diesen Effekt anscheinend ein bestimmter Abstand zwischen den schweren Halogeniden und der organischen Matrix und ein kristalliner Aufbau nötig sind. Dies würde einer kostengünstigen industriellen Fertigung von organischen Bauelementen entgegenstehen.

Die WO 2012/016074 A1 hingegen beschreibt eine dünne Schicht umfassend eine Verbindung der Formel 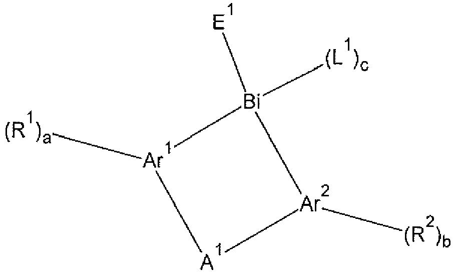 wobei Ar¹ und Ar² jeweils unabhängig ein C3-30 aromatischer Ring sind; R¹ und R² ein Substituent sind; a und b jeweils unabhängig eine ganze Zahl von 0 bis 12 sind, wobei, wenn a 2 oder mehr ist, jeder Rest R1 gegebenenfalls voneinander verschieden ist, und zwei Reste R¹ gegebenenfalls miteinander gebunden sind, um eine Ringstruktur zu bilden, und, wenn b 2 oder mehr ist, jeder Rest R² gegebenenfalls voneinander verschieden ist und zwei Reste R² gegebenenfalls miteinander gebunden sind, um eine Ringstruktur zu bilden; A¹ irgendeine Art einer direkten Bindung, -O-, -S-, -S(=O)-, -S(=O)₂-, - PR³-, -NR⁴- und -C(R⁵)₂- ist; R³ ein Wasserstoffatom oder ein Substituent ist; R⁴ ein Wasserstoffatom oder ein Substituent ist; R⁵ ein Wasserstoffatom oder ein Substituent ist und zwei Reste R⁵ gegebenenfalls voneinander verschieden sind; E¹ ein einwertiger Rest mit 50 oder weniger Kohlenstoffatomen ist; L¹ ein Ligand mit 50 oder weniger Kohlenstoffatomen ist; c eine ganze Zahl von 0 bis 3 ist, wobei, wenn c 2 oder mehr ist, jeder Rest L¹ gegebenenfalls voneinander verschieden ist; und jede Kombination einer Kombination von E¹ und Ar¹ und einer Kombination von E¹ und Ar² gegebenenfalls eine Bindung bildet; und, wenn c 1 bis 3 ist, jede Kombination einer Kombination von L¹ und E¹, einer Kombination von L¹ und Ar¹, einer Kombination von L¹ und Ar² und einer Kombination von L¹ und L¹ gegebenenfalls eine Bindung bildet. Nachteilig hingegen ist, dass die beschriebenen Verbindungen nur eine ungenügende Quantenausbeute aufweisen und in Lösung nicht ausreichend stabil sind, sodass sie sich zersetzen.

Die DE 103 60 681 A1 offenbart Hauptgruppenmetall-Diketonatokomplexe nach folgender Formel 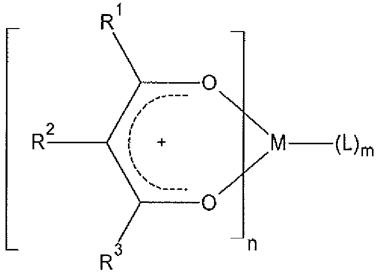 als phosphoreszente Emitter-Moleküle in organischen Leuchtdioden (OLEDs), worin M Tl(I), Pb(II) und Bi(III) sein können. Desweiteren wird die Verwendung dieser Hauptgruppenmetall-Diketonatokomplexe als Licht-emittierende Schichten in OLEDs, Licht-emittierende Schichten, enthaltend mindestens einen Hauptgruppenmetall-Diketonatokomplex, eine OLED, enthaltend diese Licht-emittierende Schicht, sowie Vorrichtungen, die eine erfindungsgemäßes OLED enthalten offenbart. In Versuchen hingegen konnte gezeigt werden, dass die unter strengen Wasserausschluss synthetisierten, oben genannten Verbindungen keine auf Phosphoreszenz basierende Emission nach elektronischer Anregung zeigen. Hochwahrscheinlich rühren die angeführten phosphoreszenten Emissionen von nicht näher bestimmbaren Oxo-Clustern her, welche sich unkontrolliert, zum Beispiel durch Hydrolyse im Rahmen der Herstellung, gebildet haben. Nachteilig an dieser speziellen Lösung ist, dass das n-System dieser Acetylacetonat-Liganden, insbesondere der beschrieben vollfluorierten Varianten, wenig ausgeprägt ist und als alleinige Phosphoreszenz-Emitter nur geringe Phosphoreszenz-Ausbeuten erlaubt. Die JP2002110357 beschreibt ein Verfahren zur Herstellung organisch elektrischer Schichten wobei ein Metallkomplex gleichzeitig mit einem organischen Liganden abgeschieden wird. Hierdurch wird ein neuer Komplex gebildet. Es ist daher die Aufgabe der vorliegenden Erfindung ein Verfahren bereitzustellen, mit welchem kostengünstig Schichten für organisch elektronische Bauelemente hergestellt werden können, welche durch die Nutzung von Phosphoreszenz eine effektive Umwandlung von Strom in Licht und umgekehrt ermöglichen.

Gelöst wird diese Aufgabe durch die Merkmale des Anspruchs 1. Besondere Ausführungsformen der Erfindung werden in den Unteransprüchen wiedergegeben.

Erfindungsgemäß ist ein Verfahren zur Herstellung organisch elektrischer Schichten aufweisend bei Raumtemperatur phosphoreszente organische Emitter, dadurch gekennzeichnet, dass organisch fluoreszente Emitter F zusammen mit Metallkomplexen enthaltend organische Komplexliganden L und mindestens ein schweres Hauptgruppenmetall M ausgewählt aus der Gruppe umfassend In, Tl, Sn, Pb, Sb und Bi, gemeinsam innerhalb einer Schicht abgeschieden werden und das schwere Hauptgruppenmetall M seine Koordinationssphäre unter Aufnahme des organisch fluoreszenten Emitters F ändert. Überraschenderweise wurde gefunden, dass mittels dieses Verfahrens einfach und kostengünstig, Schichten mit bei Raumtemperatur phosphoreszenten Emittern erhalten werden, welche eine hohe interne Quanteneffizienz, hohe Leuchtdichten, schnelles Ansprechverhalten und gute Langzeitstabilitäten aufweisen. Aufgrund der Tatsache, dass die Phosphoreszenz nur durch die organischen Emitter hervorgerufen wird, kann durch Modifikation der Liganden, insbesondere deren π-System, die Emissionswellenlänge der Emitter desweiteren durchgestimmt werden. Möglich ist insbesondere der Aufbau heteroleptischer Komplexe oder Anlagerungs-Verbindungen, welche Emissionen über die Orbitale unterschiedlich aufgebauter Liganden/Emitter ermöglicht. Dies erhöht zusätzlich die Vielfalt zur Herstellung rein organischer phosphoreszenter Emitter. Ohne durch die Theorie gebunden zu sein wird innerhalb des erfindungsgemäßen Verfahrens der zur Fluoreszenz befähigte organische Emitter in die Nähe des schweren Hauptgruppenmetalls abgeschieden, wobei sich die Koordinationssphäre des Metalls ändert. Die Änderung der Koordinationssphäre des Metalls kann dabei sowohl eine Erweiterung der Anzahl koordinierter Liganden/Emitter, einen Ersatz einer oder mehrerer Liganden durch Emitter oder sogar in der Reduzierung der Anzahl koordinierter Liganden durch die Addukt-/Anlagerungs-/Komplexbildung mit dem Emitter bestehen. Dies als Funktion der sterischen und elektronischen Voraussetzungen der Emitter und Liganden, der Koordinationsstärke der einzelnen Liganden und der Abscheidegeschwindigkeit und -Temperatur im Rahmen der gewählten Herstellung. Im Falle der Adduktbildung oder Koordination des Emitters an das schwere Hauptgruppenmetallatom muss zwischen dem Schweratom und dem organischen Emittern keine σ-Bindung ausgebildet werden. Es reichen schwache elektrostatische und/oder n-Wechselwirkungen zwischen Metall und Emitter. Durch die Wechselwirkung mit dem Schwermetallatom kann sich allerdings auch die die Energielage des HO-MOs/LUMOs des oder der fluoreszenten Emitter ändern. Bedingt durch den Schweratomeffekt kann es zudem zu einer Spin-Bahnkopplung zwischen dem Emitter-Elektronen und dem Metallatomkern kommen, welches dazu führt, dass bisher spin-verbotene elektronische Übergänge quantenmechanisch erlaubt werden. Dadurch sinkt die Lebensdauer der elektronisch angeregten Zustände und somit wird bei Raumtemperatur ein effektiver Phosphoreszenzkanal (mit Triplett-Singulett-Übergängen) eröffnet. Das Metall beteiligt sich nicht direkt an der Emission, es stellt lediglich seinen Bahndrehimpuls zur Verfügung. Dies ist im Gegensatz zu der bei Raumtemperatur rein fluoreszenten Emission der organischen Emitter ohne Schwermetallkoordination.

Die erfindungsgemäß erhaltenen Emitterschichten können dabei neutraler oder ionischer Natur sein und somit OLED oder OLECtypisches Emissionsverhalten zeigen.

Unter einer organisch elektrischen Schicht im Sinne der Erfindung wird eine Schicht umfassend organischen Emitter, Metallkomplexe enthaltend schwere Hauptgruppenmetalle und optional Matrixmaterialien verstanden. Die Schicht kann auch amorph sein, d.h. die einzelnen Bestandteile in dieser Schicht weisen keine periodische Anordnung über einen größeren Bereich (Fernordnung) auf. Insbesondere wird darunter nicht das Vorliegen eines Einkristalls oder kristalliner Bereiche mit einer Größenausdehnung von größer oder gleich 50 nm verstanden. Die in der Schicht vorliegenden Verbindungen könne aber hingegen eine gewisse Nahordnung (Abstand und Orientierung) zu Ihren nächsten Nachbarn aufweisen. Diese Bereiche sind aber statistisch verteilt. Innerhalb eines Röntgendiffraktogramms, zum Beispiel erhalten durch eine XRD-Messung (Röntgen-Pulverdiffraktometrie), zeichnet sich die amorphe Schicht durch einen breiten Halo aus. Überraschenderweise wurde gefunden, dass eine amorphe Anordnung der Bereiche in der Schicht zum Erhalt einer ausreichenden Phosphoreszenz-Ausbeute genügt. Dies im Gegensatz zu experimentellen Ergebnissen, welche eine sehr regelmäßige Anordnung einer Vielzahl von Metallatomen und Emittern als Bedingung zum Erhalt hoher Phosphoreszenz-Ausbeuten voraussetzen.

Bedingt durch den Einfluss des Schwermetalls wird bei Raumtemperatur ein nennenswerter Phosphoreszenz-Beitrag des organischen fluoreszenten Emitters erhalten. Raumtemperatur im Sinne der Erfindung ist der Temperaturbereich von -50°C bis 150°C (der übliche Betriebstemperaturbereich für organische Elektronik). In diesem Temperaturbereich liefern die phosphoreszenten Übergänge eines oder mehrerer fluoreszenter Emitter ohne Schwermetallatomeinfluss in der Regel keine nennenswerten Beiträge zur Emission rein organischer Emitter.

Organisch fluoreszente Emitter F sind organische Moleküle, welche entweder partiell oder insgesamt aromatischen Charakter mit delokalisierte n-Elektronen aufweisen können. Desweiteren können diese Moleküle Heteroatome wie N, N-R, O, S, Se, Si oder Metalle wie Li oder Al, Ga oder Zn aufweisen. R steht in diesen Fall für einen alkyl- oder aromatischen Rest. Diese Moleküle zeigen als Feststoff oder in Lösung nach elektronischer Anregung Fluoreszenz, d.h. elektronische (S1-S0) singulett-singulett Übergänge. Phosphoreszente Übergänge (T-S) sind aufgrund der quantenmechanischen Ausschlussregeln (Spinumkehr) bei Raumtemperatur nicht beobachtbar. Die Lebensdauer der fluoreszenten Übergänge in den erfindungsgemäß einsetzbaren organischen fluoreszenten Emittern kann ohne Annäherung an das schwere Metallatom in einem Bereich unterhalb von 100 ns liegen.

Bevorzugt kann es sich bei den organisch fluoreszenten Emittern F um C10-C60 Heteroaromaten, desweiteren bevorzugt um C15-C50 Heteroaromaten handeln. In speziellen Anwendungsfällen haben sich die Sauerstoff und die Stickstoff enthaltenen Heteroaromaten als besonders günstig erwiesen. Desweiteren können organisch fluoreszente Emitter bevorzugt innerhalb des erfindungsgemäßen Verfahrens eingesetzt werden, deren Triplett-Zustand größer oder gleich -5 eV und kleiner oder gleich 5 eV vom S0-Zustand entfernt ist. Mit diesen elektronischen Rahmenbedingungen können sich im Rahmen des erfindungsgemäßen Verfahrens besonders hohe Quantenausbeuten erhalten lassen.

Im Rahmen des erfindungsgemäßen Verfahrens werden Metallkomplexe enthaltend schwere Hauptgruppenmetalle M aus der Gruppe umfassend In, Tl, Sn, Pb, Sb und Bi eingesetzt. Diese Metall-komplexe können organische Komplexliganden aufweisen und sind besonders aufgrund ihrer Verfügbarkeit, ihres Beschaffungspreises und ihrer Fähigkeit zur Ausbildung einer ausgeprägten Spin-Bahnkopplung und der Möglichkeit zur Erweiterung der Koordinationsspähre bevorzugt. Es können auch mehrere unterschiedliche Metalle aus der oben genannten Gruppe im erfindungsgemäß einsetzbaren Metallkomplex enthalten sein. Diese Gruppe ist besonders geeignet, da die in ihr aufgeführten Elemente einen besonders hohen Bahndrehimpuls aufweisen, welcher effektive Phosphoreszenz-Übergänge in den organischen Emittern F ermöglicht. Zudem sind diese Metalle in hoher Reinheit zu relativ niedrigen Preisen verfügbar.

In einer besonderen Ausführungsvariante kann die Gruppe vorteilhafterweise auch Sn, Pb und Bi umfassen. Diese Metalle besitzen zudem den Vorzug, dass sie sich auch sehr gut aus Lösungen heraus verarbeiten lassen.

Bevorzugt kann die Koordination der Metalle mit organischen Liganden erfolgen, welche terminal, bidentat, tridentat oder hetero-bimetallisch mit dem Metallatom verbrückt sind. Vorteilhafte Ausgestaltungen können sich ergeben, wenn die Koordination der Liganden an das Metallatom über zwei Sauerstoffatome erfolgt. Ohne durch die Theorie gebunden zu sein, können diese Substituenten im Rahmen des Abscheideverfahrens effizient durch die organischen Emitter verdrängt oder die Koordinationssphäre erweitert werden und so zu einer hohen Phosphoreszenzausbeute beitragen. Desweiteren kann mittels dieser Substituenten die Emissionswellenlänge des Phosphoreszenzlichtes durch Ligand-Ligand-Übergänge abgestimmt werden. Bevorzugt können dieserart koordinierte Liganden aromatische π-Systeme aufweisen, welche mindestens 10 C-Atome aufweisen. Dies kann zu einer größeren Aufweitung der Emissionswellenlängen bei Ligand-Ligand-Übergängen beitragen.

Das schwere Hauptgruppenmetall M ändert unter Aufnahme des organisch fluoreszenten Emitters F seine Koordinationssphäre. Ohne durch die Theorie gebunden zu sein, wird im erfindungsgemäßen Verfahren dabei der organische Emitter in die Nähe des Hauptgruppenmetalls gebracht. Daraufhin ändert sich die Anordnung der Liganden des Metallkomplexes. Dies bedingt durch van-der-Waals-, Coulomb-, π-σ- oder σ-Wechselwirkungen des organischen Emitters mit dem Metall. Eine σ-Wechselwirkungen ist zur Ausbildung der Phosphoreszenz nicht vonnöten, kann aber auch ausgebildet werden. Die Koordinationssphäre des Metalls kann durch die Nähe des organischen Emitters aufgeweitet werden. Es kann auch zur Substitution eines einzelnen oder mehrerer Liganden durch den organischen Emitter kommen. Desweiteren ist es auch möglich, dass die Anzahl der Liganden durch die Änderung der Koordinationssphäre reduziert wird. Dies zum Beispiel durch das Verdrängen einer oder mehrerer Liganden durch die Aufnahme des fluoreszenten organischen Emitters.

Zusätzlich zum Metallkomplex und zum organischen Emitter können im Rahmen des erfindungsgemäßen Verfahrens noch weitere nicht koordinierende Matrixmaterialien innerhalb der Schicht abgeschieden werden. Dieses oder diese Matrixmaterialien können beispielsweise die elektronische Leitfähigkeit der Schicht beeinflussen oder allgemein Einfluss auf die Beweglichkeit des organischen Emitters oder des Metallkomplexes nehmen. Geeignete Matrixmaterialien können ausgewählt sein aus der Gruppe 2,2',7,7'-tetrakis(carbazol-9-yl)-9,9-spirobifluorene; 2,7-bis(carbazol-9-yl)-9,9-ditolylfluorene; 9,9-bis[4-(carbazol-9-yl)-phenyl]fluorene; 2,7-bis(carbazol-9-yl)-9,9-spirobifluorene; 1,4-bis(triphenylsilyl)benzene; 1,3-bis(triphenylsilyl)benzene; Bis(4-N,N-diethylamino-2-methylphenyl)-4-methylphenylmethane; 2,7-bis(carbazol-9-yl)-9,9-dioctylfluorene; 4,4"-di(triphenylsilyl)-p-terphenyl; 4,4'-di(triphenylsilyl)-biphenyl; 9-(4-tert-butylphenyl)-3,6-bis(triphenylsilyl)-9Hcarbazole; 9-(4-tert-butylphenyl)-3,6-ditrityl-9H-carbazole; 9-(4-tert-butylphenyl)-3,6-bis(9-(4-methoxyphenyl)-9H-fluoren-9-yl)-9H-carbazole; 2,6-bis(3-(9H-carbazol-9-yl)phenyl)pyridine; 3,5-bis(3-(9H-carbazol-9-yl)phenyl)pyridine, Triphenyl(4-(9-phenyl-9H-fluoren-9-yl)phenyl)silane; 9,9-dimethyl-N,N-diphenyl-7-(4-(1-phenyl-1Hbenzo[d]imidazol-2-yl)phenyl)-9H-fluoren-2-amine; 3,5-bis(3-(9H-carbazol-9-yl)phenyl)pyridine; 9,9-spirobifluoren-2-yl-diphenyl-phosphine oxide; 9,9'-(5-(triphenylsilyl)-1,3-phenylene)bis(9Hcarbazole); 4,4,8,8,-12,12-hexa-p-tolyl-4H-8H-12H-12C-Azadibenzo[cd,mn]pyrene; 2,2'-bis(4-(carbazol-9-yl)phenyl)-biphenyl; 2,8-bis(diphenylphosphoryl)dibenzo[b,d]Thiophene; Bis(2-methylphenyl)diphenylsilane; Bis[3,5-di(9H-carbazol-9-yl)phenyl]diphenylsilane; 3,6-bis(carbazol-9-yl)-9-(2-ethylhexyl)-9Hcarbazole; 3-(diphenylphosphoryl)-9-(4-(diphenylphosphoryl)phenyl)-9H-carbazole; 3,6-bis[(3,5-diphenyl)phenyl]-9-phenyl-carbazole; 2,8-di(9H-carbazol-9-yl)dibenzo[b,d]thiophene; 10-(4'-(diphenylamino)biphenyl-4-yl)acridin-9(10H)-one; 2,7-bis(diphenylphosphoryl)-9,9'-spirobi[fluorene]; 1,4-bis((9H-carbazol-9-yl)methyl)benzene; Bis-4-(N-carbazolyl)phenyl)phenylphosphineoxide; 2,7-Bis(diphenylphosphoryl)-9-(4-diphenylamino)phenyl-9'-phenyl-fluorene; Di(4-(6H-indolo[3,2-b]quinoxalin-6-yl)phenyl)diphenylsilane; Di(4-(6H-indolo[3,2-b]quinoxalin-6-yl)phenyl)diphenylmethane; Bis[3,5-di(9H-carbazol-9-yl)phenyl]diphenylsilane; 2,6,14-Tris(carbazol-9-yl)triptycene; 2,6,14-Tris(diphenylphosphine-oxide)triptycene; 2,6,14-Tris(diphenyl-amino)triptycene; 2,7-bis(diphenylphosphoryl)-9-phenyl-9H-carbazole; Tris[4-(9-phenylfluoren-9-yl)phenyl]aminebiphenyl-3-amine); 2,7-Bis(diphenylphosphoryl)spiro[fluorene-7,11'-benzofluorene].

Die vorliegende Erfindung wird in Verbindung mit weiteren Aspekten und Ausführungsformen nachfolgend näher beschrieben. Sie können beliebig miteinander kombiniert werden, sofern sich aus dem Zusammenhang nicht eindeutig das Gegenteil ergibt.

In einer bevorzugten Ausführungsform des Verfahrens kann das schwere Hauptgruppenmetall Bi umfassen. Bismuth hat sich aufgrund seiner ökonomischen und prozesstechnischen Eigenschaften als besonders geeignet erwiesen. Es existiert eine Vielzahl von Komplexverbindungen, welche sich im Rahmen von Nass- oder Gasphasenprozessen besonders effizient mit organischen Fluoreszenz-Emittern verarbeiten lassen. Obwohl Bismut im Periodensystem direkt hinter dem Blei folgt, hat es ganz andere physiologische Eigenschaften. Dadurch, dass es nur schwer über den Magen-Darm-Trakt aufgenommen werden kann, sind Vergiftungen mit Bismut eher selten. Im Gegenteil, Salze von Bismut werden zur Behandlung von Magengeschwüren oder Syphilis in der Medizin eingesetzt. Auch als Kontrastmittel für Röntgenuntersuchungen fand es Verwendung. Von Bismut kommt nur das Isotop mit der Masse 209 natürlich vor. Es ist mit einer Halbwertszeit von 1,9 10¹⁹ Jahren ein radioaktiver α-Strahler. Aus der langen Halbwertszeit ergibt sich für 1 kg eine Aktivität von 0,0033 Bq. Diese ist damit ca. 10 Millionen mal geringer als die des in Organismen vorkommenden Kaliums. Ein Kilogramm Kalium enthält von Natur aus 0,012 Prozent also 0,12 Gramm des radioaktiven Isotops ⁴⁰K mit einer Halbwertszeit t_{1/2} von 1,248 x 10⁹ Jahren = 39,38x10¹⁵ Sekunden, und besitzt eine Atommasse von 39,96. Daraus ergibt sich eine Radioaktivität von 31825 Bq. Damit ist die Radioaktivität des Bismuts für praktische Anwendungen vernachlässigbar klein und wäre von einem Menschen, der den Geigerzähler hält nicht einmal nachweisbar. Bismut besitzt, im Gegensatz zu Iridium (3/2)und Europium (5/2), einen Kernspin von (9/2). Dieser ist in der Lage mit ungepaarten Elektronen zu koppeln, die sich auf Liganden befinden (siehe auch "Synthesen und Eigenschaften neuer Tris(fluorphenyl)antimon- und -bismut- Verbindungen. Kristallstruktur von Tkis(2,6-difluorphenyl)bismut" von T. Lewe et al. Z. anorg. allg. Chem. 622 (1996) 2009-2015). Diese Eigenschaften und die Tatsache, dass die Bismut- im Vergleich zu den Iridiumvorkommen praktisch keiner Beschränkung unterliegen können zu einer dramatisch besseren Edukt-Kostensituation führen.

Bevorzugt können die einsetzbaren Bismuth-Komplexe Bismuth in einer Oxidationszahl von +II, +III oder +V aufweisen. Diese Oxidationszahlen haben sich als Anlagerungspunkt noch weiterer Liganden, wie zum Beispiel der organischen Emitter F, als besonders geeignet erwiesen. Die Anlagerungskinetik der organischen Emitter scheint mit diesen Oxidationszahlen des Bismuths gerade auch für eine Gasphasenabscheidung besonders geeignet. Desweiteren lassen sich die Bismuth II/III/V-Komplexe auf Basis ihrer physikalischen Daten, wie zum Beispiel der Verdampfungstemperatur oder der Löslichkeit sehr gut mittels Gasphasenabscheidungs- oder auch Nassprozessen zu Schichten formen.

Insbesondere kann die Änderung der Koordinationssphäre des Bi-Metallatoms durch eine Anlagerung von Heteroatomen eines fluoreszenten Emitters erfolgen. Es können sich dabei Anlagerungsverbindungen ergeben, in welchen sich spezielle Metall-Heteroatom-Abstände als besonders vorteilhaft herausgestellt haben. Im Falle von fluoreszenten Emittern, welche über ein Sauerstoff mit dem Bi-Schwermetallatom wechselwirken können, hat sich eine Herstellung als besonders geeignet erwiesen, im welchen der Bi-O Abstand größer oder gleich 2,25 Å und kleiner 2,75 Å, bevorzugt größer oder gleich 2,3 Å und kleiner 2,70 Å und desweiteren bevorzugt größer oder gleich 2,4 Å und kleiner 2,6 Å beträgt.
Im Falle einer Wechselwirkung über ein Cl-Heteroatom hat sich eine Herstellung als besonders geeignet erwiesen, im welchen der Bi-Cl Abstand größer oder gleich 2,3 Å und kleiner 2,9 Å, bevorzugt größer oder gleich 2,4 Å und kleiner 2,80 Å und desweiteren bevorzugt größer oder gleich 2,45 Å und kleiner 2,75 Å beträgt.
Im Falle einer Wechselwirkung über ein N-Heteroatom hat sich eine Herstellung als besonders geeignet erwiesen, im welchen der Bi-N Abstand größer oder gleich 2,3 Å und kleiner 2,9 Å, bevorzugt größer oder gleich 2,4 Å und kleiner 2,80 Å und desweiteren bevorzugt größer oder gleich 2,45 Å und kleiner 2,70 Å beträgt.
Im Falle einer Wechselwirkung über ein I-Heteroatom hat sich eine Herstellung als besonders geeignet erwiesen, im welchen der Bi-I Abstand größer oder gleich 2,6 Å und kleiner 3,2 Å, bevorzugt größer oder gleich 2,7 Å und kleiner 3,10 Å und desweiteren bevorzugt größer oder gleich 2,8 Å und kleiner 3,1 Å beträgt.
Im Falle einer Wechselwirkung über ein Br-Heteroatom hat sich eine Herstellung als besonders geeignet erwiesen, im welchen der Bi-Br Abstand größer oder gleich 2,5 Å und kleiner 3,1 Å, bevorzugt größer oder gleich 2,6 Ä und kleiner 3,0 Å und desweiteren bevorzugt größer oder gleich 2,7 Å und kleiner 2,95 Å beträgt.
Die Bindungslängen können dabei aus Einkristalldaten der betreffenden Verbindungen nach dem Fachmann bekannten Methoden bestimmt werden.
Diese Abstände der Heteroatom-enthaltenden Emitter zu dem Schwermetallatom zeigen einen ausreichenden Schwermetallatomeffekt zur Öffnung des Fluoreszenzkanals im organischen Emitter und ermöglichen zudem eine gute Wechselwirkung des organischen Emitters mit den restlichen Liganden.

In einer weiteren Ausgestaltung des Verfahrens kann der Anteil der durch elektronische inter- und intra-Liganden-Übergänge hervorgerufenen, phosphoreszenten Emission unter rein elektronischer Anregung größer oder gleich 20% und kleiner oder gleich 100% betragen. Die Aufnahme des fluoreszenten Emitters in die Koordinationssphäre des schweren Metallatoms kann einen effektiven "Phosphoreszenz-Kanal" des organischen Emitters öffnen. Zusätzlich zu einer fluoreszenten Emission können dabei auch zusätzliche Beiträge durch phosphoreszente Strahlung erhalten werden. Dies kann zu einer deutlichen Erhöhung der internen Quantenausbeute der Schicht beitragen. Die Unterscheidung, ob eine Strahlungskomponente fluoreszenten oder phosphoreszenten Ursprungs ist kann dabei anhand von zeitkorrelierter Einzelphotonenzählung (englisch time correlated single photon counting, TCSPC-Messungen) bestimmt werden. Mittels TCSPC wird die Laufzeit jedes einzelnen Photons gemessen und die Verteilung der Laufzeiten wird akkumuliert. Komponenten auf einer Mikrosekunden Zeitskala können hierbei phosphoreszenten und schnellere Übergänge fluoreszenten Übergängen zugeordnet werden. Betrachtet wird dabei jeweils die mathematische Anpassung an den gemessenen Intensitätsverlauf. Diese Methode ist dem Fachmann bekannt. Beispiele hierzu finden sich im experimentellen Teil.

In einer zusätzlichen Ausgestaltung des Verfahrens können die organisch fluoreszenten Emitter F aus der Gruppe der substituierten oder nicht substituierten C6-C60 Aromaten oder Heteroaromaten ausgewählt sein. Zum Erhalt eines möglichst großen Phosphoreszenz-Beitrages des organischen fluoreszenten Emitters und einer möglichst stabilen Assoziation des Emitters an das schwere Hauptgruppenmetall können fluoreszente Emitter in diesem Größenbereich besonders vorteilhaft eingesetzt werden. Zudem lassen sich diese Emitter sowohl gut aus der Flüssigwie auch aus der Gasphase abscheiden. Die einzelnen Moleküle können dabei sowohl vollständig aromatisch durchkonjugiert, wie auch teilweise nicht aromatische Abschnitte aufweisen.

In einer alternativen Ausführungsmöglichkeit des Verfahrens kann die längste Lebensdauer elektronisch angeregter Zustände des organisch fluoreszenten Emitters F nach Aufnahme in die Koordinationssphäre des schweren Hauptgruppenmetalls M bei Raumtemperatur größer oder gleich 0,01 Mikrosekunden und kleiner oder gleich 10000 Mikrosekunden betragen. Durch die Aufnahme des organisch fluoreszenten Emitters F in die Koordinationssphäre des schweren Hauptgruppenmetalls M kann, bedingt durch die Spin-Bahnkopplung des Metalls mit den angeregten Elektronen des organischen Emitter, eine Interkombination der Singulett- mit den Triplett-Zuständen ermöglicht werden. Diese kann den Phosphoreszenz-Kanal des Emitters "öffnen", welches zu einer höheren Quantenausbeute und längeren, beobachtbaren Lebensdauern der angeregten elektronischen Zustände des Emitters führen kann. Die Lebensdauern können mit gängigen Verfahren, wie beispielweise in den Beispielen durchgeführt mittels TCSPC bestimmt werden. Die fluoreszenten Übergänge zeichnen sich dabei durch Lebensdauern von 10⁻⁹ - 10⁻⁷ Sekunden aus, wohingegen die phosphoreszenten Übergänge üblicherweise längere Zeitkonstanten aufweisen. In Abhängigkeit der Zusammensetzung der elektrischen Schicht können auch mehrere Zeitkonstanten oder Lebensdauern vorliegen. Die längste Lebensdauer im Erfindungssinn ist diejenige, welche mit einem Anteil an der Gesamtlebensdauer von größer oder gleich 2,5 % die größte Lebensdauer aufweist.

In einer weiteren Ausgestaltung des Verfahrens können die organisch fluoreszenten Emitter F aus der Gruppe umfassend 4,7-di(9H-carbazol-9-yl)-1,10-phenanthrolin, 2,6-bis(3-(9H-carbazol-9-yl)phenyl)pyridine, 3,5-bis(3-(9H-carbazol-9-yl)phenyl)pyridine, 2,8-di(9H-carbazol-9-yl)dibenzo[b,d]thiophene, 2,2',2"-(1,3,5-Benzinetriyl)-tris(1-phenyl-1-H-benzimidazol), 2-(4-Biphenylyl)-5-(4-tert-butylphenyl)-1,3,4-oxadiazol, 2,9-Dimethyl-4,7-diphenyl-1,10-phenanthrolin, 8-Hydroxyquinolinolato-lithium, 4-(Naphthalen-1-yl)-3,5-diphenyl-4H-1,2,4-triazol, 1,3-Bis[2-(2,2'-bipyridine-6-yl)-1,3,4-oxadiazo-5-yl]benzen, 4,7-Diphenyl-1,10-phenanthrolin, 3-(4-Biphenylyl)-4-phenyl-5-tert-butylphenyl-1,2,4-triazol, Bis(2-methyl-8-quinolinolate)-4-(phenylphenolato)aluminium, 6,6'-Bis[5-(biphenyl-4-yl)-1,3,4-oxadiazo-2-yl]-2,2'-bipyridyl, 2-phenyl-9,10-di(naphthalen-2-yl)-anthracen, 2,7-Bis[2-(2,2'-bipyridine-6-yl)-1,3,4-oxadiazo-5-yl]-9,9-dimethylfluoren, 1,3-Bis[2-(4-tert-butylphenyl)-1,3,4-oxadiazo-5-yl]benzen, 2-(naphthalen-2-yl)-4,7-diphenyl-1,10-phenanthrolin, 2,9-Bis(naphthalen-2-yl)-4,7-diphenyl-1,10-phenanthrolin, Tris(2,4,6-trimethyl-3-(pyridin-3-yl)phenyl)boran, 1-methyl-2-(4-(naphthalen-2-yl)phenyl)-1H-imidazo[4,5-f][1,10]phenanthrolin, 1,3-bis(carbazol-9-yl)benzene , 1,3-bis(carbazol-9-yl)pyridine, 1,3,5-tris(carbazol-9-yl)benzene, 9-(3-(9H-carbazol-9-yl)phenyl)-3-(4-(1-phenyl-1H-benzo[d]imidazol-2-yl)phenyl)-9H-carbazole, 2,6,14-Tris(carbazol-9-yl)triptycene, 1,3-bis(carbazol-9-yl)benzene, 1,3,5-tris(carbazol-9-yl)benzene, 3,5-di(9H-carbazol-9-yl)bipheny, 9-(3,5-bis(diphenylphosphoryl)phenyl)-9H-carbazole, Bis[3,5-di(9H-carbazol-9-yl)phenyl]diphenylsilane, 2,8-bis(diphenylphosphoryl)dibenzo[b,d]thiophen, poly[3-(carbazol-9-yl)-9-(3-methyloxetan-3-ylmethyl)carbazole], Poly[3-(carbazol-9-ylmethyl)-3-methyloxetane] ausgesucht sein. Diese Verbindungen haben sich zum Einsatz als organisch fluoreszente Emitter F als besonders geeignet, aber nicht einschränkend erwiesen. Sowohl die elektronischen wie auch sterischen Eigenschaften dieser Verbindungen erlauben ausreichende Wechselwirkungen mit den schweren Hauptgruppenmetallen zur "Öffnung" des Phosphoreszenzkanals mit guten internen Quantenausbeuten und langer Standzeit der Schichten. Zudem weisen diese Verbindungen hinreichend große aromatische Bereiche auf, welches zu geeigneten Emissionswellenlängen führen kann. Die gute Wechselwirkung der organisch fluoreszenten Emitter F kann hochwahrscheinlich auch auf deren sterische Gegebenheiten und hier insbesondere auf die geeigneten Koordinationsstellen zum Metallatom zurückgeführt werden. Zudem weisen diese Verbindungen eine gute Verarbeitung in Nass- wie auch Gasphasenabscheidungsprozessen auf.

Gemäß einer weiteren Ausgestaltung des erfindungsgemäßen Verfahrens kann der organisch fluoreszente Emitter F, 4,7-di(9H-carbazol-9-yl)-1,10-phenanthrolin (BUPH1)sein. BUPH1 zeigt, hochwahrscheinlich bedingt durch seine elektronische HOMO/LUMO-Struktur, bei Raumtemperatur ohne Koordination an ein schweres Hauptgruppenmetall aus der oben angegebenen Gruppe nur reine Fluoreszenzemission. Nach Koordination oder Adduktbildung mit dem Hauptgruppenmetall werden mit hohen Quantenausbeuten phosphoreszente Emissionen beobachtbar. Diese werden im hohen Maße durch die elektronische Struktur des organischen Emitters und der restlichen Liganden des Komplexes bestimmt. Schichten mit diesem Emitter-Aufbau haben sich dabei als besonders effizient und langlebig erwiesen. Die Langlebigkeit kann dabei wahrscheinlich auf die Größe des organischen Moleküls und dessen geringe Kristallisationsneigung zurückgeführt werden.

In einer weiteren Ausgestaltung des erfindungsgemäßen Verfahrens können die Liganden des Metallkomplexes unabhängig voneinander aus der Gruppe umfassend Halogenide und fluorierte oder nicht-fluorierte C2-C20 Alkyl- oder Aryl-Carboxylate, - Alkoholate, -Thiolate, -Cyanate, -Isocyanate, -Thiocyanate, - Acetylacetonate, -Sulfonate ausgewählt sein. Diese Liganden im Metallkomplex können zu einer leichten Verarbeitbarkeit in Nass- wie auch Gasphasenprozessen beitragen und können aufgrund Ihrer Koordinationseigenschaften zum Metallatom zu einer einfachen Änderung der Koordinationssphäre des Metallatoms beitragen. Innerhalb des Metallkomplexes kann/können dabei nur ein oder aber auch mehrere der oben genannten Liganden vorliegen. Bevorzugt kann der Komplex gemischte Liganden aufweisen. Dies entweder durch Erweiterung der Koordinationssphäre des Metalls oder durch Ersatz eines einzelnen oder mehrerer Liganden. Diese Liganden können zudem zur Justage der Emissionswellenlänge des organischen Emitters genutzt werden. Dies kann durch elektronische Wechselwirkungen des oder der Liganden mit dem Emitter hervorgerufen werden. Diese Liganden L im Metallkomplex können bevorzugt einen Anteil von größer oder gleich 0 % und kleiner oder gleich 20 % an der gesamten Emissionsausbeute der Schicht ausmachen. Bevorzugt kann dieser Bereich zwischen größer oder gleich 0 % und kleiner oder gleich 10 % und desweiteren bevorzugt zwischen größer oder gleich 0 % und kleiner oder gleich 5 % liegen.

Desweiteren können in einem weiteren Aspekt des Verfahrens die Liganden L des Metallkomplexes unabhängig voneinander aus der Gruppe umfassend C6-C30 Aromaten und Heteroaromaten ausgewählt sein. Diese Aromaten oder Heteroaromaten können zu einer leichten Verarbeitbarkeit in Nass- wie auch Gasphasenprozessen beitragen und ermöglichen den organischen Emittern zudem eine einfache Koordination an das Metallatom. Die Wechselwirkungen der π-Elektronen können zudem die Lage der Phosphoreszenz-Wellenlängen des organischen Emitters beeinflussen und so zu einem veränderten Emissionsspektrum beitragen.

In einer weiteren bevorzugten Ausführungsform kann der Metallkomplex ein Bi(III) und mindestens einen Komplexliganden aus der Gruppe der nicht substituierten, partiell fluorierten oder per-fluorierten organischen Carbonsäuren enthalten. Bevorzugt kann der Metallkomplex ein, zwei oder drei dieser organischen Carbonsäuren enthalten. Organische Carbonsäuren können dabei generell aus der Gruppe der aliphatisch, gesättigten Monocarbonsäuren; aliphatisch, ungesättigten Monocarbonsäuren; aliphatisch, gesättigten Dicarbonsäuren; aliphatisch, gesättigte Tricarbonsäuren; aliphatisch, ungesättigten Dicarbonsäuren; aromatischen Carbonsäuren; heterocyclischen Carbonsäuren; aliphatisch, ungesättigten, cyclischen Monocarbonsäuren ausgewählt werden. Besonders bevorzugte partielle oder perfluorierte Liganden L können aus substituierten oder unsubstituierten Verbindungen der Essigsäure, Phenylessigsäure und/oder Benzoesäure ausgewählt werden. Besonders bevorzugt kann nicht-fluorierte, partiell fluorierte oder perfluorierte Essigsäure eingesetzt werden. In einer weiteren bevorzugten Ausführungsform können ein oder mehrere mehrzähnige Liganden L im unverdampften Zustand verbrückend zwischen den Metallatomen des Komplexes angeordnet sein. Diese Verbindungen lassen sich einfach sowohl aus der Nassphase als auch über ein Gasphasenabscheidungsverfahren verarbeiten und ermöglichen eine gute Anbindung des fluoreszenten Emitters in der Schicht. Sie können derart zu langlebigen Emitter-Bauteilen führen, welche eine sehr gute Quantenausbeute aufweisen.

Besonders bevorzugt können die Bi(III)-Metallkomplexe als Ausgangsstoffe nach unten angegebenen Strukturen dabei entweder ein-kernig 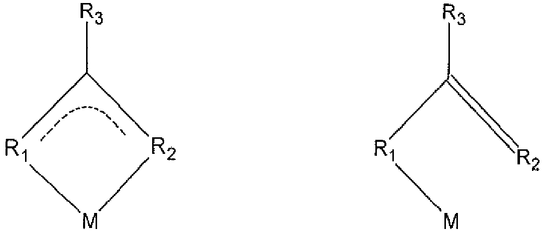 oder nach weiter unten angegebenen Strukturen zwei-kernig aufgebaut sein: 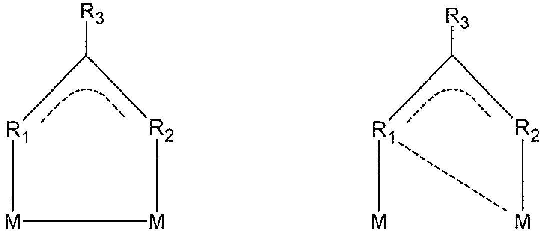 wobei R¹ und R² unabhängig voneinander Sauerstoff, Schwefel, Selen, NH oder NR⁴ sein können, wobei R⁴ ausgewählt ist aus der Gruppe enthaltend Alkyl oder Aryl und mit R³ verbunden sein kann; und
R³ ausgewählt ist aus der Gruppe enthaltend Alkyl, langkettiges Alkyl, Alkoxy, langkettiges Alkoxy, Cycloalkyl, Halogenalkyl, Aryl, Arylene, Halogenaryl, Heteroaryl, Heteroarylene, Heterocycloalkylene, Heterocycloalkyl, Halogenheteroaryl, Alkenyl, Halogenalkenyl, Alkinyl, Halogenalkinyl, Ketoaryl, Halogenketoaryl, Ketoheteroaryl, Ketoalkyl, Halogenketoalkyl, Ketoalkenyl, Halogenketoalkenyl, wobei bei geeigneten Resten eine oder mehrere nichtbenachbarte CH₂-Gruppen unabhängig voneinander durch -O-, -S-, -NH-, -NR°-, -SiR°R°°-, -CO-, -COO-, -OCO-, -OCO-O-, -SO₂-, -S-CO-, -CO-S-, -CY1=CY2 oder -C≡C- ersetzt sein können und zwar derart, dass O und/oder S Atome nicht direkt miteinander verbunden sind, ebenfalls optional mit Aryl- oder Heteroaryl bevorzugt enthaltend 1 bis 30 C Atome ersetzt sind (endständige CH₃-Gruppen werden wie CH₂-Gruppen im Sinne von CH₂-H verstanden)
Ohne durch die Theorie gebunden zu sein ergibt sich bei den ein-kernigen Komplexen eine terminale Koordination des Metalls über den/die Liganden. Im Falle eines zwei-kernigen Komplexes ergibt sich eine zwei- oder drei-zähnige Koordination des Metallatoms. Diese Koordinationsgeometrie kann den Zutritt eines fluoreszenten Emitters erleichtern und so zu einer effektiven Komplex oder Adduktbildung beitragen. Desweiteren zeigen diese Verbindungen in Schichten gute elektrische Eigenschaften und eine geringe Kristallisationsneigung, sodass langlebig hohe Quantenausbeuten erhältlich sein können.

In einer weiteren Charakteristik des erfindungsgemäßen Verfahrens kann der Metallkomplex eine oder mehrere Verbindungen aus der Gruppe Trisarylbismuth(V)biscarboxylat und Bi(III)triscarboxylat umfassen. Das Trisarylbismuthcarboxylat ergibt sich nach folgender Formel 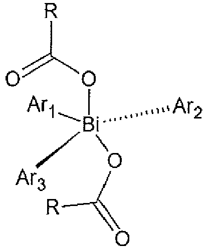 wobei Ar₁, Ar₂ und Ar₃ unabhängig voneinander substituierte oder nicht substituierte, fluorierte order nicht fluorierte Aromaten oder Heteroaromaten bezeichnen. Diese Verbindungen lassen sich besonders leicht mittels Nassphasen- oder Gasphasenabscheidung verarbeiten und ermöglichen eine gute Koordination der organischen fluoreszenten Emitter an das Bi-Zentralatom. Die so erhaltenen Schichten zeichnen sich durch eine hohe Quantenausbeute und eine geringe Kristallisationsneigung aus. Dieses kann die Lebensdauer der Schichten erhöhen.

Desweiteren kann in einem weiteren Aspekt des Verfahrens der Metallkomplex eine oder mehrere Verbindungen aus der Gruppe ganz oder teilweise fluoriertes Triphenylbismuth(V)bis-(fluorobenzoat) und Bi(III)pentafluorobenzoat umfassen. Diese Verbindungen lassen sich besonders leicht mittels Nassphasen- oder Gasphasenabscheidung verarbeiten und ermöglichen eine gute Koordination der organischen fluoreszenten Emitter an das Bi-Zentralatom. Die so erhaltenen Schichten zeichnen sich durch eine hohe Quantenausbeute und eine geringe Kristallisationsneigung aus. Dieses kann die Lebensdauer der Schichten erhöhen.

In einer zusätzlichen Charakteristik des Verfahrens kann der Metallkomplex eine oder mehrere Verbindungen aus der Gruppe Bi(III)fluorobenzoat, Bi(III)fluoroalkylbenzoat, Bi(III)fluorodialkylbenzoat, Bi(III)fluorotrialkyl-benzoat Bi(III)pentafluorobenzoat und Bi(III)3,5trifluormethyl-benzoat umfassen. Diese Verbindungen mit Bi in der Oxidationsstufe III und Benzoat-Sustituenten lassen sich besonders leicht mittels Nassphasen- oder Gasphasenabscheidung verarbeiten und ermöglichen eine gute Koordination der organischen fluoreszenten Emitter an das Bi-Zentralatom. Die so erhaltenen Schichten zeichnen sich durch eine hohe Quantenausbeute und eine geringe Kristallisationsneigung aus. Dieses kann die Lebensdauer der Schichten erhöhen. Die Fluorierung kann dabei sowohl nur ein einzelnes H-Atom bis hin zu einer Perfluorierung der Verbindung erfassen. Die Alkyl-Gruppen können dabei vorzugsweise C1-C5-Akyl sein und falls nicht näher spezifiziert, können 1-4 Positionen des Grundkörpers unabhängig voneinander alkyliert sein.

In einem weiteren Aspekt des Verfahrens kann der Metallkomplex eine oder mehrere Verbindungen aus der Gruppe der Trisarylbismuth(V)carboxylate umfassen. Diese Verbindungen mit Bi in der Oxidationsstufe V lassen sich besonders leicht mittels Nassphasen- oder Gasphasenabscheidung verarbeiten und ermöglichen eine gute Koordination der organischen fluoreszenten Emitter an das Bi-Zentralatom. Die so erhaltenen Schichten zeichnen sich durch eine hohe Quantenausbeute und eine geringe Kristallisationsneigung aus. Dieses kann die Lebensdauer der Schichten erhöhen. Die Fluorierung kann dabei sowohl nur ein einzelnes H-Atom bis hin zu einer Perfluorierung der Verbindung erfassen. Eine bevorzugte Verbindung dieser Verbindungslasse ist beispielsweise ganz oder teilweise fluoriertes Triphenylbismuth(V)bis(fluorobenzaat).

In einer weiteren, bevorzugten Ausführungsform kann der Metallkomplex aus der Gruppe umfassend Bi(III)triscarboxylat, Bi(III)fluoroacetat und Bi(III)trifluoroacetat ausgewählt sein. Gerade die Koordination der Liganden über zwei Sauerstoffatome an das schwere Hauptgruppenmetall kann eine erleichterte Änderung der Koordinationssphäre durch den Eintritt des organischen Fluoreszenz-Emitters ermöglichen. Durch diese Konfiguration können besonders stabile und effiziente Schichten mit langen Lebensdauern hergestellt werden.

In einer zusätzlichen Ausgestaltung des Verfahrens kann der Metallkomplex und der organisch fluoreszente Emitter F auf einem Trägersubstrat mittels Ko-Evaporation, Rotations-, Vorhangbeschichtung, Rakeln oder Drucken abgeschieden werden. Besonders bevorzugt kann die amorphe Schicht mittels Gasphasenabscheidung oder Nassprozessen hergestellt werden. Mittels dieser Verfahren können der Metallkomplex und der organische Fluorezenz-Emitter zusammen abgeschieden werden und so die amorphe Schicht bilden. Beide Substanzen können im Rahmen eines Ko-Evaporationsverfahrens dabei aus unterschiedlichen Quellen unter Einsatz thermischer Energie sublimiert werden. Mittels dieser Verfahren erhält man besonders homogene und gleichmäßige Schichten. Lösemittelprozesse können bevorzugt so durchgeführt werden, dass die Komponenten aus einem Lösemittel auf ein Substrat abgeschieden werden. Dies kann die Prozessführung vereinfachen und eine günstigere Herstellung ermöglichen. Zusätzlich können noch weitere Materialien wie zum Beispiel Matrixmaterialien, welche nicht an das Metallatom koordinieren in dem Lösungsmittel gelöst und/oder innerhalb der Schicht mit abgeschieden werden. Ebenso können diese Matrixmaterialien aus weiteren Quellen zusätzlich mit verdampft werden.

In einer weiteren Charakteristik des erfindungsgemäßen Verfahrens kann das molare Verhältnis von Metallkomplex zu organisch fluoreszenten Emitter F größer oder gleich 1:10 und kleiner oder gleich 10:1 betragen. Diese Mengenverhältnisse von Metallkomplex zu organischen Emitter innerhalb der Schicht haben sich zum Erhalt hoher Leuchtdichten und einer langen Lebensdauer der Schichten als besonders vorteilhaft erwiesen. Höhere Anteile an Metallkomplex können zwar durch die Veränderung der Schichtleitfähigkeit zu einer Erhöhung der Phosphoreszenz-Ausbeute führen, dieser Effekt kann aber auch durch andere Verbindungen bei niedrigeren Materialkosten erreicht werden. Geringere Anteile an Metallkomplex können hingegen zu einer nur ungenügenden Aktivierung des Phosphoreszenz-Pfades führen. Dies kann für die interne Quantenausbeute der Schicht nachteilig sein. Bevorzugt beträgt das molare Verhältnis von Metallkomplex zu organisch fluoreszenten Emitter F größer oder gleich 1:5 bis 5:1 und desweiteren besonders bevorzugt 1:3 bis 3:1.

Zusätzlich kann im erfindungsgemäßen Verfahren die Abscheidung des Metallkomplex und des organisch fluoreszenten Emitters F mittels eines Ko-Evaporationsverfahrens erfolgen und die Abscheiderate der organisch elektrischen Schicht größer oder gleich 0,1 Å/s und kleiner oder gleich 200 Å/s betragen. Die Öffnung des Phosphoreszenz-Kanals des organischen Emitters ist im Wesentlichen mit der Koordinationsänderung des schweren Hauptgruppenmetalls M durch die Aufnahme des oder Adduktbildung mit dem organischen Emitter gekoppelt. Die räumliche Nähe des Emitters zum Metall ermöglicht dabei eine Spin-Bahnkopplung, welche zu einer reduzierten Lebensdauer angeregter Triplett-Zustände des organischen Emitters führt. Überraschenderweise wurde gefunden, dass diese Abstände zwischen Emitter und Metall auch mittels Ko-Evaporation herbeigeführt werden können. Dies ist deshalb überraschend, da man als Voraussetzung für das Vorliegen hoher Quantenausbeuten einen möglichst definierten Abstand, wie z.B. in Einkristallen oder bei kristallinen Strukturen gegeben, als Voraussetzung erwarten würde. Dies lässt sich aber bei einer Herstellung mittels Ko-Evaporation nicht erwarten, da die einzelnen Moleküle ungeordnet, amorph, innerhalb einer Schicht abgeschieden werden. Durch dieses Verfahren lassen sich lösungsmittelfreie Schichten mit langer Lebensdauer erhalten. Die bevorzugte Abscheiderate kann dabei zu einem gleichmäßigen Schichtaufbau beitragen. Kleinere Abscheideraten sind nicht erfindungsgemäß, da diese die Herstellung aufgrund des Zeitaufwandes deutlich verteuern würden. Höhere Raten sind desweiteren nicht erfindungsgemäß, da die Quantenausbeute sich aufgrund einer ungenügenden Abstandseinstellung zwischen Metall und organischen Emitter verringern kann. Bevorzugt kann die Abscheiderate desweiteren größer oder gleich 0,1 Å/s und kleiner oder gleich 150 Å/s und weiterhin bevorzugt größer oder gleich 1,0 Å/s und kleiner oder gleich 100 Å/s betragen.

Desweiteren erfindungsgemäß ist eine Schicht in einem organisch elektrischen Bauelement hergestellt nach dem erfindungsgemäßen Verfahren. Mittels des erfindungsgemäßen Verfahrens lassen sich Schichten in organisch elektrischen Bauelementen herstellen, welche zur Emission und Umwandlung von Licht geeignet sind. Die Schichten können eine Schichtdicke von größer oder gleich 1 nm und kleiner oder gleich 500 µm aufweisen und mittels der vorher beschriebenen Verfahren aufgetragen werden. Im Rahmen von Ko-Evaporationsprozessen erhält man die Schicht durch das direkte Aufbringen der Substanzen aus der Gasphase, wohingegen bei Nassprozessen, die Schicht nach Evaporation des oder der Lösemittel erhalten wird.

Zusätzlich kann die erfindungsgemäße Schicht als aktive Schicht in einem organisch elektrischen Bauelement zur Umwandlung elektrischen Stroms in Licht, von Licht in elektrischen Strom und von Licht in Licht anderer Wellenlänge Verwendung finden. Die erfindungsgemäße Schicht lässt sich demzufolge zur Gewinnung von Strom durch Absorption von Lichtwellen als auch zur Erzeugung von Licht mittels eines elektrischen Stromes nutzen. Desweiteren kann die Schicht auch zur Umwandlung von Lichtwellen in Lichtwellen einer anderen Wellenlänge genutzt werden. Dies beispielsweise durch Aufnahme von Lichtquanten und Abgabe von Lichtquanten anderer Wellenlänge.

Erfindungsgemäß ist weiterhin ein organisches Halbleiterbauelement ausgewählt aus der Gruppe umfassend Photodioden, Solarzellen, organische Leuchtdioden, Licht emittierende elektrochemische Zellen enthaltend die erfindungsgemäße Schicht. Das beschriebene Verfahren und die damit herstellbaren Schichten können entsprechend für absorbierende Bauelemente wie Photodioden oder Solarzellen Verwendung finden. Desweiteren können die Schichten auch für Photo-Konversionsschichten in der Photovoltaik oder Sensorik eingesetzt werden. Das Verfahren ist mit den Standard-Herstellungsschritten dieser Bauelemente kompatibel und derart lassen sich kostengünstig, langlebige und effiziente Bauelemente erhalten.

Hinsichtlich weiterer Vorteile und Merkmale der vorbeschriebenen organischen Halbleiterbauelemente wird hiermit explizit auf die Erläuterungen im Zusammenhang mit der erfindungsgemäßen Schicht sowie dem erfindungsgemäßen Verfahren verwiesen. Auch sollen erfindungsgemäße Merkmale und Vorteile des erfindungsgemäßen Verfahrens auch für die erfindungsgemäße Schichten und die erfindungsgemäßen organischen Halbleiterbauelemente anwendbar sein und als offenbart gelten und umgekehrt. Unter die Erfindung fallen auch sämtliche Kombinationen aus zumindest zwei von in der Beschreibung und/oder den Ansprüchen offenbarten Merkmalen.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Die Eigenschaften der gewählten Edukte und die Eigenschaften der erfindungsgemäßen Schichten werden nachfolgend anhand von Figuren näher erläutert. Die Figuren zeigen
- Fig. 1: schematisch den Aufbau einer organischen Leuchtdiode 10. Die Leuchtdiode ist aus einer Glas-Schicht 1; Indium-Zinn-Oxid ITO-Schicht 2; Loch-Injektor-Schicht 3; Loch-Transportschicht HTL 4; Emitter-Schicht EML 5; Loch-Blocker-Schicht HBL 6; Elektronen-Transportschicht ETL 7; Elektronen-Injektorschicht 8 und einer Kathoden-Schicht 9 aufgebaut;
- Fig. 2: schematisch den Aufbau einer organischen Solarzelle mit PIN-Struktur 20, welche Licht 21 in elektrischen Strom umwandelt. Die Solarzelle besteht aus einer Schicht aus Indium-Zinn-Oxid 22; einer pdotierten Schicht 23; einer Absorptions-Schicht 24; einer n-dotierten Schicht 25 und einer Metall-Schicht 26;
- Fig. 3: die Photolumineszenz-Spektren von festen und in THF gelösten BUPH1 bei Raumtemperatur;
- Fig. 4: die Photolumineszenz-Spektren von BUPH1 in 2-Methyl-THF bei 77 K;
- Fig. 5: das zeitkorrelierte Einzelphotonenzählungs-(TCSPC)-Spektrum von BUPH1 in THF zur Bestimmung der Fluoreszenz-Lebensdauer des BUPH1;
- Fig. 6: das Cyclo-Voltagramm von BUPH1 in Acetonitril;
- Fig. 7: die UV-Absorptionsspektren von Bi(tfa)₃, Bi(pFBz)₃ und Bi(3,5tfmBz)₃ zusammen mit einer Tauc-Darstellung;
- Fig. 8: die Auftragung der molaren Extinktionskoeffizienten von Bi(tfa)₃, Bi(pFBz)₃ und Bi(3,5tfmBz)₃ in THF gegen die Wellenlänge;
- Fig. 9: die UV-Absorptionsspektren von BUPH1, Bi(tfa)₃ und mit unterschiedlich Abscheidungsraten durch Ko-Evaporation hergestellter Bi(tfa)₃:BUPH1-Schichten;
- Fig. 10: die UV-Absorptionsspektren von BUPH1 und mit unterschiedlich Abscheidungsraten durch Ko-Evaporation hergestellter Bi(pFBz)₃:BUPH1-Schichten;
- Fig. 11: das normierte Photolumineszenzspektrum von BUPH1 und mit unterschiedlich Abscheidungsraten durch Ko-Evaporation hergestellter Bi(tfa)₃:BUPH1-Schichten;
- Fig. 12: das normierte Photolumineszenzspektrum von BUPH1 und mit unterschiedlich Abscheidungsraten durch Ko-Evaporation hergestellter Bi(pFBz)₃:BUPH1-Schichten;
- Fig. 13: das XRD-Spektrum eines Bi(tfa)₃:BUPH1 (1:1)-Films;
- Fig. 14: die UV-Absorptionsspektren im Bereich zwischen 250 und 475 nm von SnCl₂-BUPH1-Addukten oder -Komplexen mit unterschiedlicher Zusammensetzung. Dargestellt sind die UV-Absorptionsspektren von 1:1, 1:2 und 1:3 Addukten oder Komplexen in THF bei Raumtemperatur;
- Fig. 15: die UV-Absorptionsspektren im Bereich zwischen 350 und 475 nm von SnCl₂-BUPH1-Addukten oder -Komplexen mit unterschiedlicher Zusammensetzung. Dargestellt sind die UV-Absorptionsspektren von 1:1, 1:2 und 1:3 Addukten oder Komplexen in THF bei Raumtemperatur. Die Daten entsprechen den Ergebnissen aus Figur 14 und sind nur vergrößert und ausschnittsweise dargestellt;
- Fig. 16: das normierte Photolumineszenz-Spektrum von SnCl₂-BUPH1-Addukten oder -Komplexen mit unterschiedlicher Zusammensetzung (1:1, 1:2 und 1:3) in THF bei Raumtemperatur. Die Anregungswellenlänge betrug 410 nm.
- Fig. 17: das zeitkorrelierte Einzelphotonenzählungs-(TCSPC)-Spektrum von 1:1 SnCl₂-BUPH1-Addukten oder - Komplexen in THF bei Raumtemperatur. Dargestellt ist zudem die mathematische Anpassung;
- Fig. 18: das zeitkorrelierte Einzelphotonenzählungs-(TCSPC)-Spektrum von 1:2 SnCl₂-BUPH1-Addukten oder - Komplexen in THF bei Raumtemperatur. Dargestellt ist zudem die mathematische Anpassung;
- Fig. 19: das zeitkorrelierte Einzelphotonenzählungs-(TCSPC)-Spektrum von 1:3 SnCl₂-BUPH1-Addukten oder - Komplexen in THF bei Raumtemperatur. Dargestellt ist zudem die mathematische Anpassung;
- Fig. 20: die UV-Absorptionsspektren im Bereich zwischen 250 und 475 nm von PbTFA-BUPH1-Addukten oder -Komplexen mit unterschiedlicher Zusammensetzung. Dargestellt sind die UV-Absorptionsspektren von 1:1, 1:2 und 1:3 Addukten oder Komplexen in THF bei Raumtemperatur;
- Fig. 21: die UV-Absorptionsspektren im Bereich zwischen 350 und 430 nm von PbTFA_BUPH1-Addukten oder -Komplexen mit unterschiedlicher Zusammensetzung. Dargestellt sind die UV-Absorptionsspektren von 1:1, 1:2 und 1:3 Addukten oder Komplexen in THF bei RaumtemperaFig. 22 tur. Die Daten entsprechen den Ergebnissen aus Figur 20 und sind nur vergrößert und ausschnittsweise dargestellt; das normierte Photolumineszenz-Spektrum von PbTFA-BUPH1-Addukten oder -Komplexen mit unterschiedlicher Zusammensetzung (1:1, 1:2 und 1:3) in THF bei Raumtemperatur. Die Anregungswellenlänge betrug 410 nm.
- Fig. 23: das zeitkorrelierte Einzelphotonenzählungs-(TCSPC)-Spektrum von 1:1 PbTFA_BUPH1-Addukten oder - Komplexen in THF bei Raumtemperatur. Dargestellt ist zudem die mathematische Anpassung;
- Fig. 24: das zeitkorrelierte Einzelphotonenzählungs-(TCSPC)-Spektrum von 1:2 PbTFA_BUPH1-Addukten oder - Komplexen in THF bei Raumtemperatur. Dargestellt ist zudem die mathematische Anpassung
- Fig. 25: das zeitkorrelierte Einzelphotonenzählungs-(TCSPC)-Spektrum von 1:3 PbTFA_BUPH1-Addukten oder - Komplexen in THF bei Raumtemperatur. Dargestellt ist zudem die mathematische Anpassung.

### Beispiele:

Im Rahmen des erfindungsgemäßen Verfahrens wird ein organischer Fluoreszenz-Emitter durch Wechselwirkung mit einem schweren Hauptgruppenmetall (In, Tl, Sn, Pb, Sb, Bi) innerhalb einer Schicht oder in Lösung zu einer auf Phosphoreszenz basierenden Aussendung oder Aufnahme von Licht befähigt. Zur Veranschaulichung des Prinzips werden Verbindungen mit den Hauptgruppenmetallen Bi, Pb und Sn vorgestellt.

Als organischer Fluoreszenz-Emitter wird 4,7-di(9H-carbazol-9-yl)-1,10-phenanthrolin (BUPH1) eingesetzt.

Charakterisierung des organischen Fluoreszenz-Emitters

BUPH1 ist ein ungeladenes, neutrales organisches Molekül folgenden Aufbaus 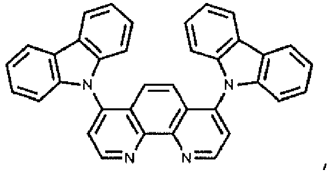 wobei ein elektronentransportierender Phenanthrolin-Kern mit zwei Löcher-transportierenden Carbazol-Einheiten verbunden ist. Die Verbindung ist eine bidentate Lewis-Base und die beiden Stickstoffe des Kerns können, ebenso wie die π-Elektronensysteme der Aromaten mit geladenen Metallen wechselwirken.

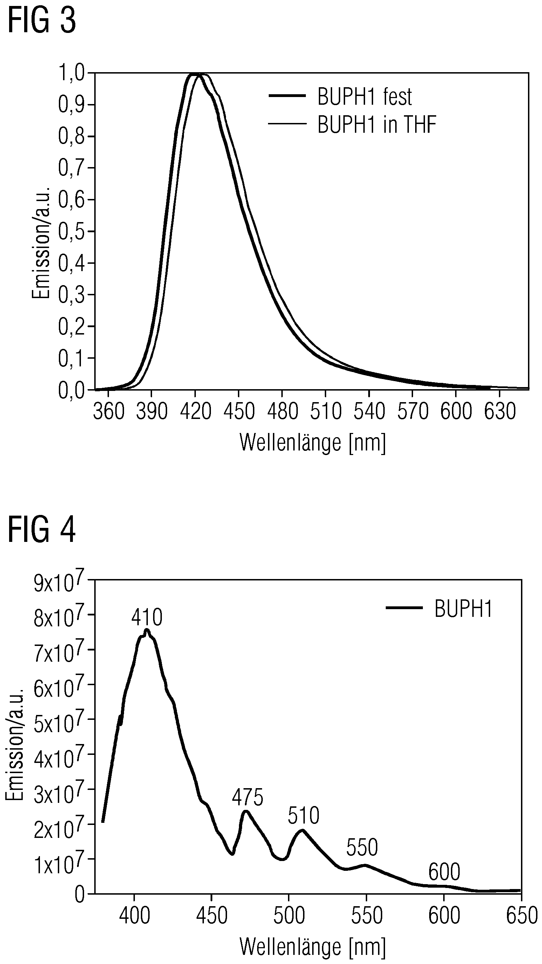

In Figur 3 sind die Spektren des festen BUPH1 und des BUPH1 gelöst in Tetrahydrofuran (THF) dargestellt. Das BUPH1 zeigt bei Raumtemperatur eine blaue Photolumineszenz mit einer maximalen Emission des festen Materials bei 420 nm und der in THF-gelösten Verbindung bei 425 nm. Die Wellenlängenverschiebung von 5 nm ergibt sich aufgrund der Polarität des gewählten Lösungsmittels.

In Figur 4 ist das Photolumineszenz-Spektrum von BUPH1 in 2-Methyl-THF bei 77 K gezeigt. Die Verbindung zeigt 5 Emissionsmaxima bei 410, 475, 510, 550 und 600 nm. Aufgrund der Tatsache, dass die Maxima bei 475, 510, 550 und 600 nm deutlich tiefer liegen als bei 410 nm kann darauf geschlossen werden, dass diese Emissionen aus dem Triplett-Zustand erfolgen und folglich von Phosphoreszenzübergängen (T1→S0) herrühren. Allgemein ist diese Quantenausbeute geringer, da dieser Übergang Spin-verboten ist. Desweiteren spricht auch die Stokes-Verschiebung der Emissionen bei 475, 510, 550 und 600 nm für das Vorliegen eines Phosphoreszenzüberganges des BUPH1 bei tiefen Temperaturen. Phosphoreszente Übergänge liegen, verglichen mit Fluoreszenzübergängen, immer in der Energie tiefer. Desweiteren spricht die Tatsache, dass die 475, 510, 550 und 600 nm Emissionen im Raumtemperaturspektrum fehlen auch für das vorliegen von Triplett-Emissionen. Daraus folgt, dass das erste Emissionsmaximum einem Fluoreszenz- und die weiteren Übergänge Phosphoreszenz-Übergängen zugeordnet werden können. Die Energie des Triplett-Überganges liegt im Vergleich mit anderen Lewis-Basen erstaunlicherweise mit 2,6 eV (475 nm) sehr hoch.

Die Photolumineszenz Quantenausbeute (englisch photoluminescence quantum yield - PLQY) von BUPH1 wurde in THF Lösung bestimmt. PLQY eines Fluorophors (Emitter) gibt das Verhältnis zwischen der Anzahl der emittierten und absorbierten Photonen an. Eine Methode zur Berechnung wird zum Beispiel in Albert M. Brouwer Pure Appl. Chem., Vol. 83, No. 12, pp. 2213-2228, 2011 angegeben. Die BUPH1-PLQY in THF liegt, unter Verwendung von 9,10Diphenylantharacene in Cyclohexan als Referenz, bei 29,8 %.

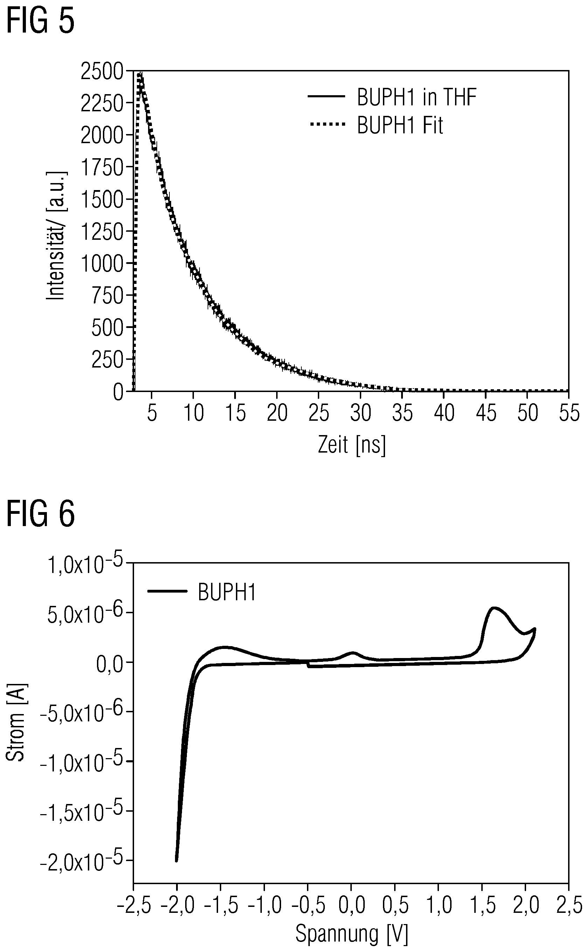

Figur 5 zeigt das zeitkorrelierte Einzelphotonenzählungs-(TCSPC)-Spektrum von BUPH1 in THF zur Bestimmung der Fluoreszenz-Lebensdauer. Die Figur zeigt den exponentiellen Photolumineszenz-Abfall als Funktion der Zeit. Das Experiment wurde in inerter Atmosphäre mit λₑₓ 295 nm, λₑₘ 420nm und TAC 50ns durchgeführt. Der TAC ("time to amplitude", Zeit/Amplituden-Umwandler) ist ein Teil des TCSPC Spektrometer, das ein Ausgangssignal mit einer Amplitude proportional zum Zeitintervall zwischen Eingangs "Start-" und "Stopp-"Impulsen erzeugt. Die Amplitudenverteilung der Ausgangsimpulse wird dann von einem Multichannel-Analyzer aufgezeichnet. Sie ist somit ein Maß für die Verteilung der Zeitintervalle zwischen den Start- und Stopp-Impulsen und wird oft als "Zeitspektrum" bezeichnet. Die Daten können mit einer einzelnen Exponentialfunktion angepasst werden, woraus sich eine Lebensdauer von 7,06*10⁻⁹ s für BUPH1 in THF bei Raumtemperatur ergibt (CHISQ = 1.14). Dies bedeutet, dass die Lebensdauer des angeregten Zustandes bei Raumtemperatur auf einer Nanosekunden-Zeitskala liegt, welches einem fluoreszenten Übergang, mit einer üblichen Lebensdauer von 10⁻⁹ bis zu 10⁻⁷ s, entspricht.

In Figur 6 ist das Cyclo-Voltagramm von BUPH1 in Acetonitril dargestellt. Die Messung wurde mit Pt/Pt Elektroden gegen eine Ag/AgCl Referenzelektrode mit einer Rate von 20 mV/s aufgenommen. Aus dem Oxidationspotential von BUPH1 (nach BUPH1⁺) von 1,43 V lässt sich die Energie des HOMO-Levels berechnen. Man erhält eine HOMO-Lage des BUPH1 von 5,82 eV.

### A. Beispiele unter Einsatz des schweren Hauptgruppenmetalls Bi

### I. Charakterisierung der eingesetzten Metall-Komplexe

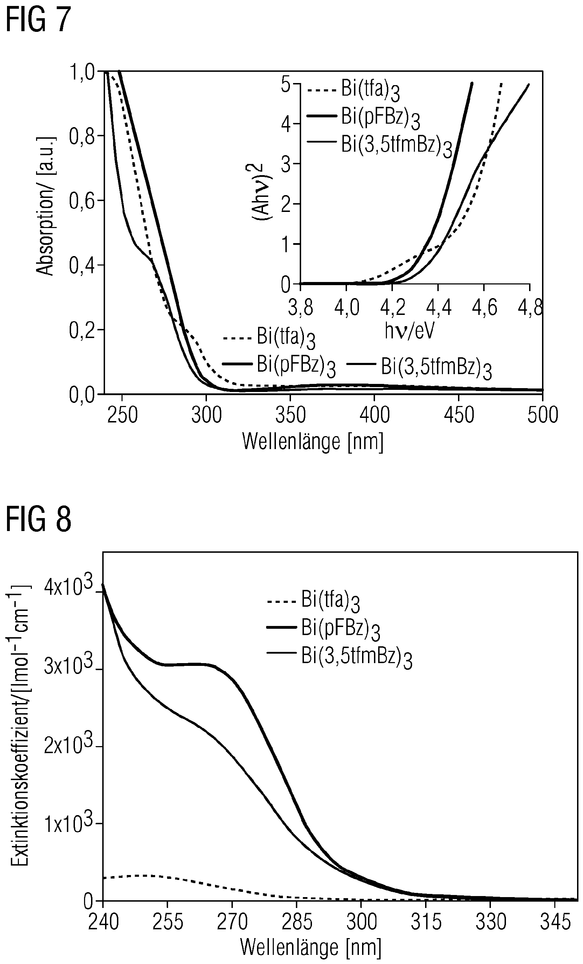

In Figur 7 sind die UV-Absorptionsspektren von Bi(tfa)₃, Bi(pFBz)₃ und Bi(3,5tfmBz)₃ dargestellt. Die Strukturformeln der Verbindungen sind weiter unten aufgeführt.

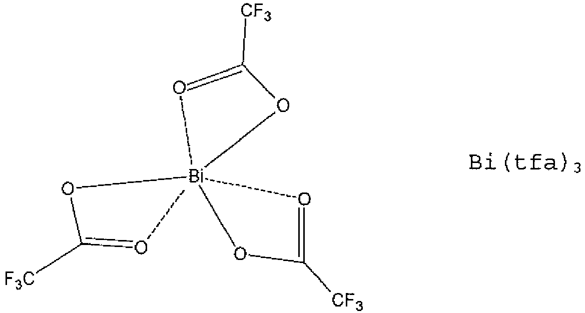

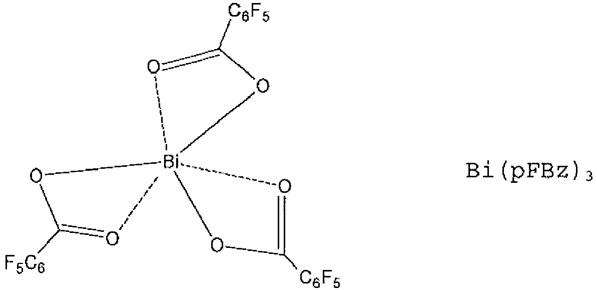

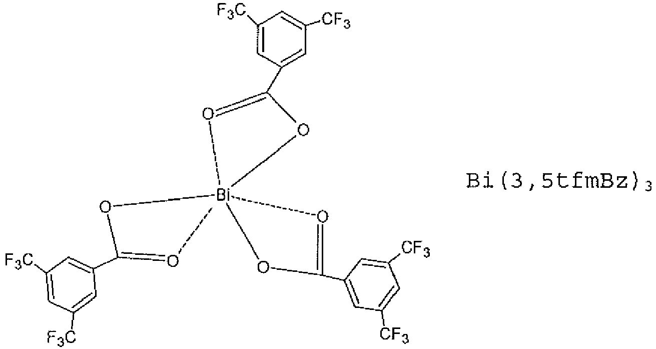

Die einzelnen Spektren zeigen eine starke n-π* und π-π* Absorption, welche auf die Carboxylat-Liganden und das Bi-Zentralatom zurückgeführt werden kann. Die Bi-Carboxylate absorbieren Licht nur in der UV-Region des Spektrums, deshalb erscheinen sie als weißer Festkörper. Der eingeschobene Graph zeigt eine Tauc-Auftragung mit welcher der optische Bandabstand der einzelnen Verbindungen bestimmt werden kann. Die Graphen zeigen ein lineares Regime, welches den Startpunt der Absorption markiert. Extrapoliert man dieses lineare Regime zur Abzisse, so erhält man die Energie des optischen Bandabstandes. Für Bi(tfa)₃, Bi(pFBz)₃ und Bi(3,5tfmBz)₃ ergibt sich eine relativ große Bandlücke im Bereich von 4,46, 4,32 und 4,34 eV. Damit ergibt sich, dass die Bi-Carboxylate Isolator-Eigenschaften zeigen.

Die Figur 8 zeigt die Auftragung der molaren Extinktionskoeffizienten von Bi(tfa)₃, Bi(pFBz)₃ und Bi(3,5tfmBz)₃ in THF gegen die Wellenlänge. Bei 265 nm beträgt der Exintinktionskoeffizient für Bi(tfa)₃, Bi(pFBz)₃ und Bi(3,5tfmBz)₃ 243, 3065 und 2200 Lmol⁻¹cm⁻¹. Im Falle des Bi(pFBz)₃ und des Bi(3,5tfmBz)₃ sind die n-π* und die π-π* Übergänge erlaubt, welches zu Extinktionskoeffizienten von über 1000 Lmol⁻¹cm⁻¹ führt.

### II. Herstellung der Schichten

Ein vorgefertigtes Quarzsubstrat wird für 10 Minuten mittels eines Sauerstoffplasmas behandelt und schnellstmöglich in einen Evaporator überführt, welcher sich innerhalb einer Argon gefüllten Glovebox mit einem Wassergehalt kleiner 2 ppm befindet.

Das thermische Verdampfen erfolgt bei einem Basisdruck kleiner als 2x10⁻⁶ mbar, welcher während des gesamten Bedampfungsschrittes beibehalten wird.

Der Metallkomplex und der organische Emitter werden gleichzeitig auf eine Temperatur kurz unterhalb ihres Verdampfungspunktes aufgeheizt. Anschließend wird der Metallkomplex solange weiter aufgeheizt, bis eine konstante Verdampfungsrate erzielt ist. Ebenso verfährt man mit dem organischen Emitter und bei beidseitig konstanten Verdampfungsratenraten wird der Schieber des Evaporators geöffnet.

Die Abscheiderate beider Substanzen wird auf 1 Å/s eingestellt, wobei die Konzentration des Bismuth-Komplexes in Abhängigkeit zum gewünschten Bi:BUPH1-Verhältnis eingeregelt wird, z.B. eine Konzentration von 50% wird mit einer BUPH1 Abscheiderate von 0,5 Å/s und einer Bi-Abscheiderate von 0,5 Å/s erreicht. Dies entspricht einem Verhältnis von 1:1.

Nach erfolgter Bedampfung werden beide Quellen auf unter 40°C herab gekühlt und der Verdampfer mit trockenem Argon geflutet.

Es wurden eine Reihe Bi:BUPH1-Filme mit unterschiedlicher Zusammensetzung über das oben beschriebene Ko-Evaporationsverfahren hergestellt. Damit wurden 200 nm dicke Bi:BUPH1-Filme als Emitterschichten auf einem Quarzglas abgeschieden. Es wurden folgende Verhältnisse eingestellt(die Abkürzungen von Bismuth(III)trifluoroacetat Bi(tfa)₃ und die von Bi(III)Pentafluorobenzoat Bi(pFBz)₃):

| Verbindung | Verhältnis |
|---|---|
| Bi(tfa)₃ : BUPH1 | 1:1 |
| Bi(tfa)₃ : BUPH1 | 1:2 |
| Bi(tfa)₃ : BUPH1 | 1:3 |
| Bi(tfa)₃ : BUPH1 | 1:4 |
| Bi(tfa)₃ : BUPH1 | 0:1 |
| Bi(tfa)₃ : BUPH1 | 3:1 |
| Bi(pFBz)₃ : BUPH1 | 1:1 |
| Bi(pFBz)₃ : BUPH1 | 1:2 |
| Bi(pFBz)₃ : BUPH1 | 1:3 |

### III. Charakterisierung der durch Ko-Evaporation hergestellten Schichten

### III.a UV-Absorption

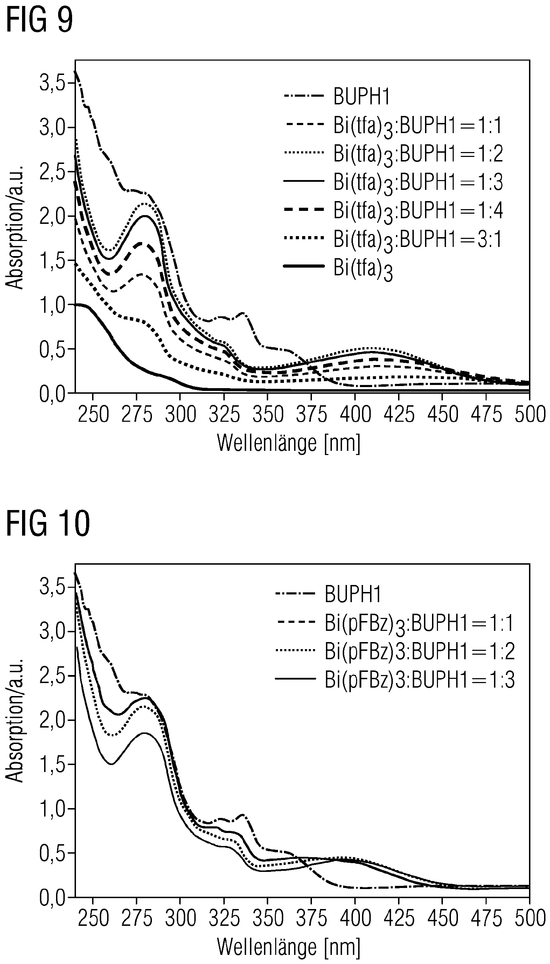

Die Figur 9 zeigt die UV-Absorptionsspektren von BUPH1, Bi(tfa)₃ und mit unterschiedlich Abscheidungsraten durch Ko-Evaporation hergestellter Bi(tfa)₃:BUPH1-Schichten. Die Schichtdicke beträgt 200 nm. Es sind für die Filme zwei Haupt-Absorptionsbanden sichtbar. Die dominierende Absorptionsbande liegt zwischen 230-350 nm und kann einem Spinerlaubten π-π* Übergang am BUPH1 zugeordnet werden. Im Vergleich zu dem reinen BUPH1-Film fehlt in den Komposit-Schichten (Metall + Emitter) der n-π* Übergang des BUPH1 bei 335 nm. Dies deutet auf eine Koordination der freien Stickstoff Elektronenpaare an das Bismut hin. Daraus folgt, dass das BUPH1 unter Bildung eines Adduktes oder Komplexes mit dem Bismuth wechselwirkt. Desweiteren zeigt das Absorptionsspektrum der Komposit-Filme eine niedrig liegende Absorptionsbande von 350 nm - 500 nm, welche bis in den sichtbaren Bereich hineinreicht. Diese Bande kann wahrscheinlich einem intraliganden Ladungstransfer zugeordnet werden.

In Figur 10 sind die UV-Absorptionsspektren von BUPH1 und mit unterschiedlich Abscheidungsraten durch Ko-Evaporation hergestellter Bi(pFBz)₃:BUPH1-Schichten dargestellt. Die Schichtdicke beträgt jeweils 200 nm. Im Vergleich zu dem reinen BUPH1-Film fehlt in den Komposit-Schichten der n-π* Übergang des BUPH1 bei 335 nm. Dies deutet auf eine Koordination des freien Stickstoff Elektronenpaares an das Bismut hin. Daraus folgt, dass das BUPH1 unter Bildung eines Adduktes oder Komplexes an das Bismuth bindet/koordiniert. Desweiteren zeigt das Absorptionsspektrum der Komposit-Filme eine niedrig liegende Absorptionsbande von 350 nm - 500 nm, welche bis in den sichtbaren Bereich hineinreicht. Diese Bande kann wahrscheinlich einem intraliganden Ladungstransfer zugeordnet werden.

### III.b Photolumineszenz

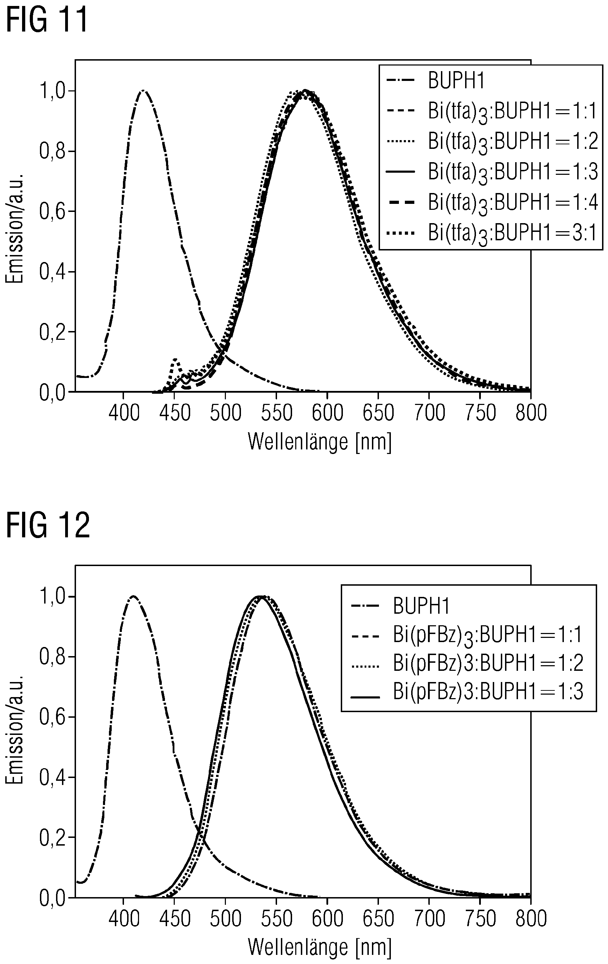

Figur 11 zeigt das normierte Photolumineszenzspektrum von BUPH1 und mit unterschiedlich Abscheidungsraten durch Ko-Evaporation hergestellter Bi(tfa)₃:BUPH1-Schichten. Die Schichtdicke betrug jeweils 200 nm. Die Emissionsspektren sind auf die maximale Intensität des BUPH1-Films hin normiert. Das Emissionsmaximum liegt für BUPH1 bei 420 und für die Komposit-Schichten bei 585 nm. BUPH1-Film λex: 365 nm, λem 420 nm; Bi(tfa)3:BUPH1 = 1:1 λex: 410 nm, λem 585 nm; Bi(tfa)3:BUPH1 = 1:2 λex: 410 nm, λem 580 nm; Bi(tfa)3:BUPH1 = 1:3 λex: 410 nm, λem 585 nm; Bi(tfa)3:BUPH1 = 1:4 λex: 410 nm, λem 585 nm; Bi(tfa)₃:BUPH1 = 3:1 λex: 410 nm, λem 585 nm. Im Vergleich mit dem Tieftemperatur-Emissionsspektrum von BUPH1, welche Emissionsmaxima bei 520, 550 und 5600 nm aufwies, zeigt das Anlagerungsaddukt oder der -Komplex nur eine breite Phosphoreszenz-Emissionsbande bei Raumtemperatur.

Die Figur 12 zeigt das normierte Photolumineszenzspektrum von BUPH1 und mit unterschiedlich Abscheidungsraten durch Ko-Evaporation hergestellter Bi(pFBz)₃:BUPH1-Schzchten. Die Schichtdicke beträgt jeweils 200 nm. BUPH1 λex: 335 nm λem 420 nm; Bi(pFBz)3:BUPH1 = 1:1 λex:395 nm, λem 535 nm; Bi(pFBz)3:BUPH1 = 1:2 λex: 395 nm, λem 542 nm; Bi(pFBz)3:BUPH1 = 1:3 λex:395 nm, λem 540 nm. Die Komposit-Schichten zeigen eine maximale Emission bei 550 nm. Durch Vergleich mit Figur 11 ergibt sich, dass die Emission bei höheren Wellenlängen zwischen den unterschiedlichen Bi-Komplexen unterschiedlich ist. Dies wahrscheinlich aufgrund der Tatsache, dass die Metall-Liganden (Trifluoracetat oder Pentafluoracetat) die Emissionswellenlängen des erhaltenen Bi:BUPH1-Adduktes oder Komplexes beeinflussen können. Im Vergleich mit dem Tieftemperatur-Emissionsspektrum des BUPH1, welche Emissionsmaxima bei 520, 550 und 5600 nm aufwies, zeigt der Komplex nur eine breite Phosphoreszenz-Emissionsbande bei Raumtemperatur.

### III.c Photolumineszenz Quantenausbeute (PLQY)

Die Photolumineszenz Quantenausbeute (PLQY) von Komposit-schichten konnte nicht in solid State bestimmt werden. Aus diesem Grund wurden die Schichten von Bi(tfa)₃:BUPH1 1:2 und Bi(pFBz)3:BUPH1 1:2 in Dichlormethan gelöst und die PLQY in Lösung gemessen. Die PLQY von Bi(tfa)₃:BUPH1 1:2 beträgt 3,7% (Coumarin 153 in Ethanol als Referenz). Für Bi(pFBz)₃:BUPH1 liegt die PLQY bei 6% (Coumarin 153 in Ethanol als Referenz). Diese Werte der PLQY liegen deutlich über den PLQY anderer Bismut Komplexe aus der Literatur, welche in der Regel unterhalb 1 % liegen. Beispielsweise genannt sei eine PLQY in Höhe von 0,2 % für Dithienobismol, erhalten nach der WO 2011 111621 A1.

### III.d Zeitkorrelierte Einzelphotonenzählung TCSPC

Die mit unterschiedlichen Zusammensetzungen abgeschiedenen Bi(tfa)₃:BUPH1- und Bi(pFBz)₃:BUPH1-Filme wurden mittels TCSPC-Messungen (time-correlated single photon counting) in einer inerten Atmosphäre untersucht. Bei Raumtemperatur liefert die TCSCP-Messung für die Bi:BUPH1-Filme komplexe Lebensdauern im Mikrosekunden-Bereich. Dies ist ein klarer Hinweis für das Vorliegen eines Phosphoreszenzüberganges. Die Ergebnisse der Messungen an den einzelnen Filmen sind in den folgenden Tabellen dargestellt.

Die Ergebnisse für die Bi(tfa)₃:BUPH1-Filme

| Film, 200 nm, 500 ns TAC Range | | | | | | |
|---|---|---|---|---|---|---|
| Bi(tfa)₃:BUPH1 Ratio | T1/s | B1/% | T2/s | B2/% | T3/s | B3/% |
| | *10⁻⁹ | | *10⁻⁸ | | *10⁻⁷ | |
| 1:1 | 2,68 | 46,96 | 2,03 | 15,70 | 1,42 | 21,05 |
| 1:2 | 3,80 | 10,00 | 2,98 | 11,27 | 1,46 | 71,08 |
| 1:3 | 3,58 | 21,48 | 2,54 | 15,16 | 1,27 | 54,08 |
| 1:4 | 2,46 | 32,35 | 3,10 | 14,89 | 1,21 | 28,56 |

Die Ergebnisse für die Bi(pFBZ)₃:BUPH1-Filme

| Film, 200 nm, 5 µs TAC Range | | | | |
|---|---|---|---|---|
| Bi(pFBz)₃:BUPH1 Ratio | T1/s | B1/% | T2/s | B2/% |
| | *10⁻⁷ | | *10⁻⁶ | |
| 1:1 | 4,30 | 32,64 | 1,18 | 63,05 |
| 1:2 | 4,71 | 26,51 | 1,33 | 79,86 |
| 1:3 | 1,50 | 3,86 | 0,98 | 96,15 |

Wie aus den Graphen ersichtlich ist offenbar die Strahlungslebensdauer der Emitter in den Bi(tfa)₃:BUPH1-Filmen im Vergleich zu den Emittern in den Bi(pFBz)₃:BUPH1-Filmen etwas kürzer. Anscheinend führt der Einsatz von Bi(tfa)₃ zu einer stärkeren Spin-Bahnkopplung des organischen Emitters, welches den Phosphoreszenz-Übergang des BUPH1 in diesem Komplex quantenmechanisch stärker erlaubt. Dies wiederum führt im Vergleich zu Bi(pFBz)₃ zu einer kürzeren Strahlungslebensdauer. Der Lewis-Säurecharakter von Bi(tfa)₃ ist im Vergleich zu Bi(pFBz)₃ höher, was in diesem Beispiel zu einer verstärkten Wechselwirkung führt.

Anzumerken ist weiterhin, dass die Strahlungslebensdauer der Emitter in den Bi(tfa)₃:BUPH1-Filmen mittels einer tri-Exponentialfunktion, die der Bi(pFBz)₃:BUPH1 Filme mit einer di-Exponentialfunktion, angepasst wurden. Dies kann darauf hindeuten, dass ein ganzes Ensemble von Molekülen im Film aktiv ist und an der Emission teilnimmt.

### III.e XRD-Spetrum

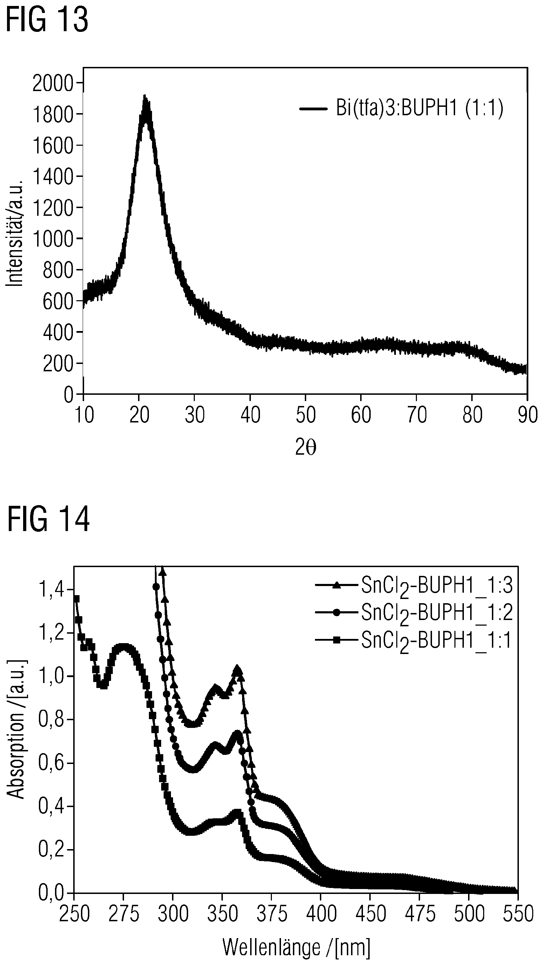

In Figur 13 ist das XRD-Spektrum eines Bi(tfa)₃:BUPH1 (1:1)-Films dargestellt. Die Schichtdicke des Bi(tfa)₃:BUPH1 (1:1) Filmes beträgt 2 µm. Der Film erzeugt im Röntgendiffraktogramm nur einen breiten Halo über einen weiten 2-Theta Bereich, welches für eine amorphe Anordnung der Metallkomplex-Emitter-Verbindungen spricht. Dies bedeutet, dass die einzelnen phosphoreszenten Ensembles unregelmäßig, amorph, in der Schicht angeordnet sind. Dies kann darauf zurückzuführen sein, dass es sich um gemischt stöchiometrische Verbindungen im Film handelt oder, dass sich aufgrund der gewählten Herstellmethodik keine Fernordnung zwischen den einzelnen Emitter-Ensembles einstellen kann.

### B. Beispiele unter Einsatz des schweren Hauptgruppenmetalls Sn

Als weiteres Beispiel von Emittern, die ein schweres Hauptgruppenmetall enthalten und bei Raumtemperatur Phosphoreszenz aufweisen werden Sn-Verbindungen eingesetzt. Als Metallausgangsstoff wurde Zinn(II)-Chlorid (SnCl₂) verwendet. BUPH1 ist ein organisch fluoreszenter Emitter, welcher durch schwache elektrostatische und/oder π-Wechselwirkungen mit dem Schweratom wechselwirkt. Durch den Einfluss des Schwermetalls werden bisher spin-verbotene elektronische Übergänge von BUPH1 quantenmechanisch erlaubt und es wird ein nennenswerter Phosphoreszenz-Beitrag bei Raumtemperatur erhalten. Diese Ergebnisse zeigen die prinzipielle Eignung dieser Verbindungsklasse auch für den Einsatz in Schichten organisch elektrischer Bauelemente.

### I. Herstellung von Sn-BUPH1-Komposit Lösungen in THF

In 3 ml Tetrahydrofuran (THF) Lösung lässt man SnCl₂ und BUPH1 in einem Verhältnis von 1:1, 1:2 oder 1:3 reagieren und untersucht diese Lösung dann spektroskopisch. Es wurden 5 µl SnCl₂ (10⁻² M in THF) und 5 µl BUPH1 (10⁻² M in THF) in 3 ml THF eingesetzt, um ein Stoffmengenverhältnis von 1:1 zu erhalten.

### II. Charakterisierung der hergestellten Lösungen

### II.a UV-Absorption

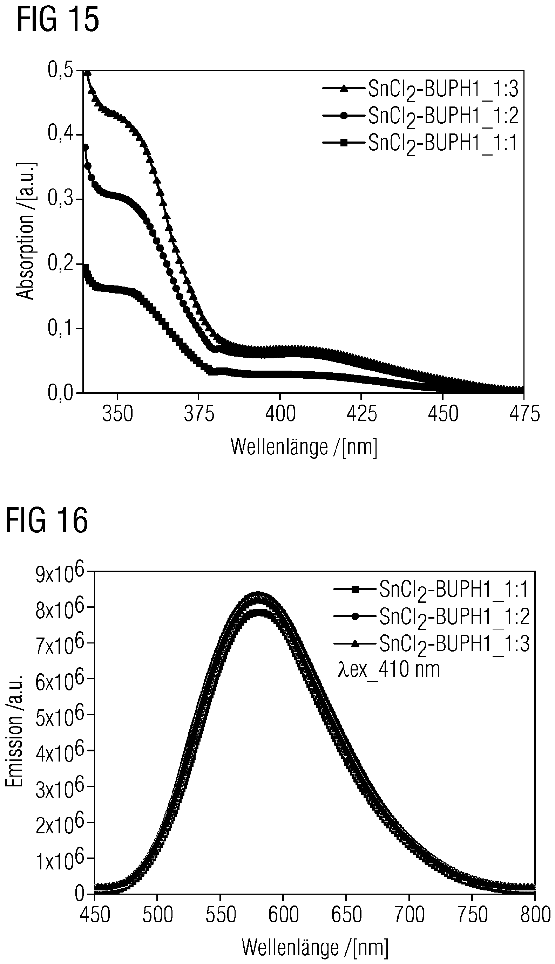

Die Figur 14 zeigt die UV-Absorptionsspektren von SnCl₂-BUPH1 in THF in unterschiedlichen Stoffmengenverhältnissen (1:1, 1:2 und 1:3). Die Absorptionsbanden in den Komposit-THF-Lösungen von SnCl₂-BUPH1 zwischen 250-375 nm sind identisch mit den optischen Übergängen von BUPH1 (vergleiche Fig. 3)in diesem Bereich. Die Intensitätserhöhung der Absorptionsbanden von SnCl₂-BUPH1 ist proportional zu der Konzentration an BUPH1 in der Lösung. Interessanterweise zeigt das Absorptionsspektrum der Komposit-THF-Lösungen zusätzlich eine niedrig liegende Absorptionsbande im Bereich von 375 - 450 nm, welche bis in den sichtbaren Bereich hineinreicht. Dieser Bereich ist in Figur 15 vergrößert dargestellt. Diese Bande kann wahrscheinlich einem Intraliganden-Ladungstransfer des gebildeten BUPH1-Sn-Adduktes oder -Komplexes zugeordnet werden.

### II.b Photolumineszenz

Die Figur 16 zeigt die Photolumineszenzspektren von SnCl₂-BUPH1 in THF Lösung in einem Stoffmengenverhältnis von 1:1, 1:2 und 1:3. Die Spektren wurden mit einer Wellenlänge von 410 nm angeregt, da wahrscheinlich bei dieser Wellenlänge der Intraligand-Ladungstransfer stattfindet, welcher für die Phosphoreszenz-Emissionsbande verantwortlich zeichnet. Die Komposit-THF-Lösungen zeigen eine maximale Emission bei 580 nm und die Intensität der Banden ändert sich kaum mit der Erhöhung der BUPH1 Konzentration in Lösung. Ohne durch die Theorie gebunden zu sein, wird die Emission hauptsächlich durch BUPH1 verursacht, welches aufgrund des Einflusses des Schwermetalls Zinn auf die spin-verbotenen elektronischen Übergänge zur Phosphoreszenz befähigt wird. Im Vergleich mit dem Tieftemperatur-Emissionsspektrum von BUPH1 (vgl. Fig. 4), welches Emissionsmaxima bei 520, 550 und 600 nm aufweist, zeigt das SnCl₂-BUPH1 Anlagerungsaddukt oder der -Komplex eine breite Phosphoreszenz-Emissionsbande bei Raumtemperatur.

### II.c Zeitkorrelierte Einzelphotonenzählung TCSPC

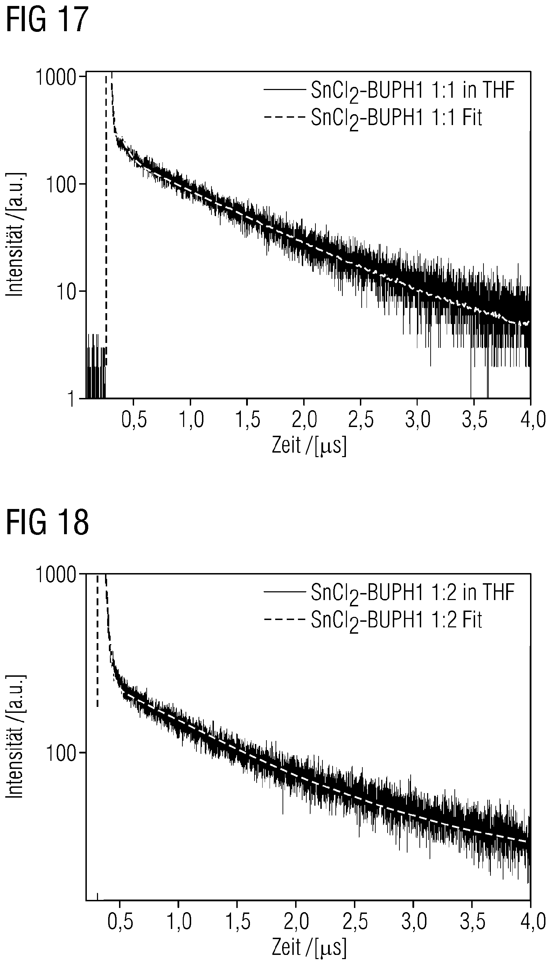

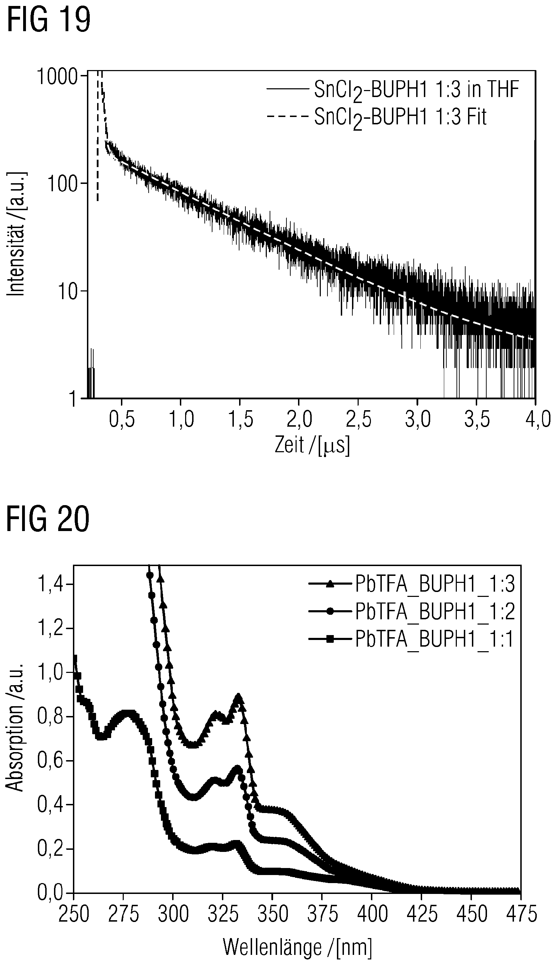

Die mit unterschiedlichen Stoffmengenverhältnissen hergestellten SnCl₂-BUPH1 Lösungen wurden mittels zeitkorrelierter Einzelphotonenzählung-Messungen in einer inerten Atmosphäre (Argon) untersucht. Bei Raumtemperatur liefert die TCSCP-Messung für die SnCl₂-BUPH1 Anlagerungsaddukte oder -Komplexe Lebensdauern im Mikrosekunden-Bereich(Mengenverhältnis 1:1 in Figur 17, 1:2 in Figur 18 und 1:3 in Figur 19). Dies ist ein klarer Hinweis für das Vorliegen eines Phosphoreszenzüberganges. Die Ergebnisse der Messungen an den einzelnen Proben sind in unten stehender Tabelle dargestellt.

| **SnCl₂:BUPH1 Stoffmengenverhältnis** | **T1/ µs** |
|---|---|
| 1:1 | 0,84 |
| 1:2 | 1,12 |
| 1:3 | 0,76 |

Die Spektren wurden auf einer 5 µs Zeitskala gemessen, wobei die Phosphoreszenz-Lebensdauer der untersuchten Komposit-THF Lösungen sich im Bereich von 0,76 bis 1,12 Mikrosekunden bewegen.

### C. Beispiele unter Einsatz des schweren Hauptgruppenmetalls Pb

Als weiteres Beispiel von Emittern, die ein schweres Hauptgruppenmetall enthalten und bei Raumtemperatur Phosphoreszenz aufweisen werden Pb-Verbindungen eingesetzt. Diese Ergebnisse zeigen die prinzipielle Eignung dieser Verbindungsklasse auch für den Einsatz in Schichten organisch elektrischer Bauelemente.

### I Herstellung von Pb-BUPH1-Komposit Lösungen in THF

3 ml THF Lösung lässt man PbTFA (Blei-Trifluoroacetat) und BUPH1 in einem Verhältnis von 1:1, 1:2 oder 1:3 reagieren und untersucht die Lösung dann spektroskopisch. Es wurden 5 µl PbTFA (10⁻² M in THF) und 5 µl BUPH1 (10⁻² M in THF) in 3 ml THF eingesetzt, um ein Stoffmengenverhältnis von 1:1 zu erhalten.

### II. Charakterisierung der hergestellten Lösungen

### II.a UV-Absorption

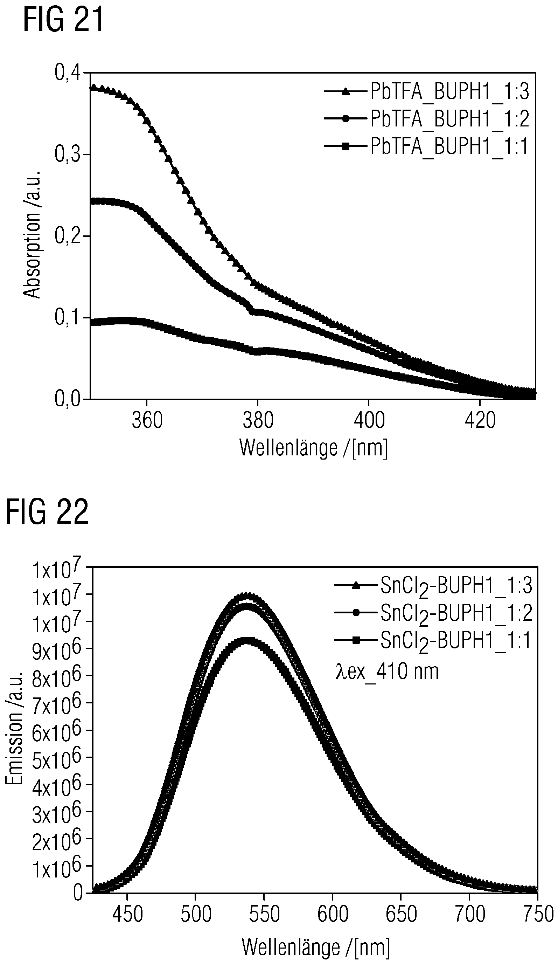

Die Figuren 20 und 21 zeigen die UV-VIS Absorptionsspektren von PbTFA-BUPH1 in THF in einem Stoffmengenverhältnis von 1:1, 1:2 und 1:3.

Die Absorptionsbanden in den Komposit-THF-Lösungen von PbTFA-BUPH1 zwischen 250-375 nm sind identisch mit den optischen Übergängen von BUPH1 in diesem Bereich. Die Intensitätserhöhung der Absorptionsbanden von PbTFA-BUPH1 ist proportional zu der Konzentration von BUPH1 in der Lösung. Interessanterweise zeigt das Absorptionsspektrum der Komposit-THF-Lösungen zusätzlich eine niedrig liegende Absorptionsbande im Bereich von 375 nm - 415 nm (Figur 21), welche sich bis in den sichtbaren Bereich erstreckt. Diese Bande kann wahrscheinlich einem intraliganden Ladungstransfer des gebildeten BUPH1-Pb-Adduktes oder -Komplexes zugeordnet werden.

### II.b Photolumineszenz

Figur 22 zeigt das Photolumineszenz-Spektrum von PbTFA-BUPH1 in THF Lösung mit einem Stoffmengenverhältnis von 1:1, 1:2 und 1:3. Die Verbindungen wurden mit einer Wellenlänge von 410 nm angeregt, da wahrscheinlich bei dieser Wellenlänge der Intraligand-Ladungstransfer stattfindet, welcher für die Phosphoreszenz-Emissionsbande verantwortlich zeichnet. Die Komposit-THF-Lösungen zeigen eine maximale Emission bei 536 nm und die Intensität der Banden ändert sich kaum mit der Erhöhung der BUPH1 Konzentration in Lösung. Ohne durch die Theorie gebunden zu sein, wird die Emission hauptsächlich durch BUPH1 verursacht, welches aufgrund des Einflusses des Schwermetalls Blei auf die spin-verbotenen elektronischen Übergänge zur Phosphoreszenz befähigt wird. Im Vergleich mit dem Tieftemperatur-Emissionsspektrum von BUPH1 (siehe Figur 3), welche Emissionsmaxima bei 520, 550 und 600 nm aufweist, zeigt das PbTFA-BUPH1 Anlagerungsaddukt oder der -Komplex eine breite Phosphoreszenz-Emissionsbande bei Raumtemperatur.

### II.c Zeitkorrelierte Einzelphotonenzählung TCSPC

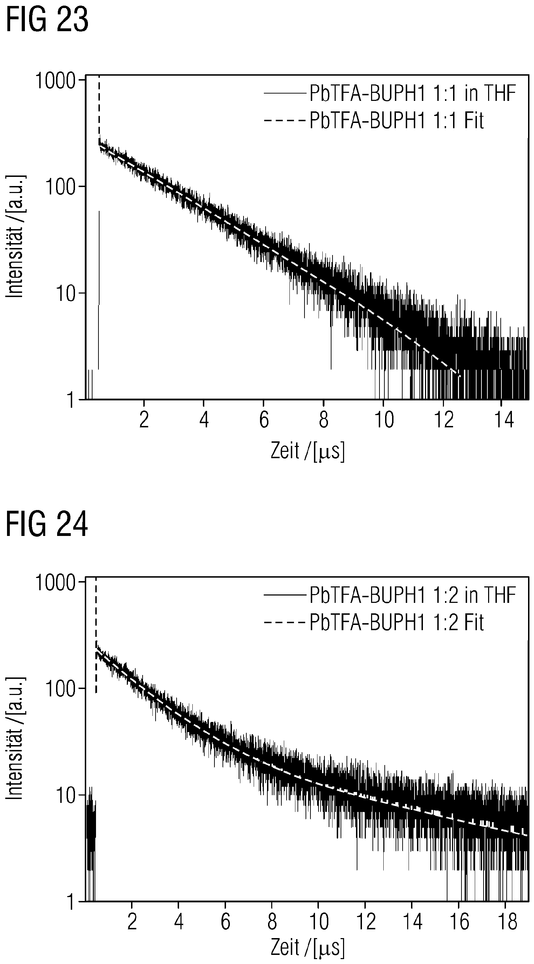

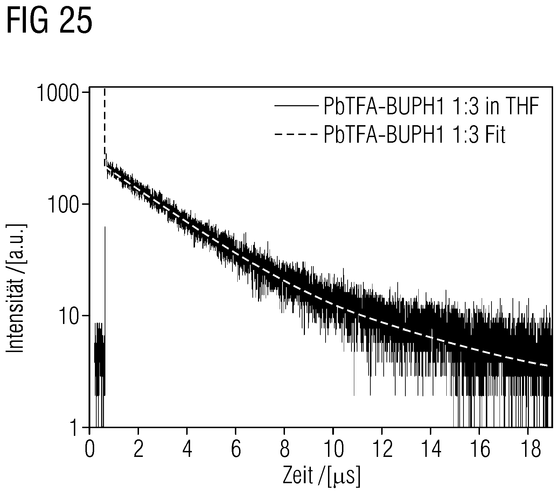

Die mit unterschiedlichen Stoffmengenverhältnissen hergestellten PbTFA-BUPH1 Lösungen wurden mittels zeitkorrelierter Einzelphotonenzählung-Messungen in einer inerten Atmosphäre (Argon) untersucht. Bei Raumtemperatur liefert die TCSCP-Messung für die PbTFA-BUPH1 Anlagerungsaddukte oder -Komplexe Lebensdauern im Mikrosekunden-Bereich (Mengenverhältnis 1:1 in Figur 23, 1:2 in Figur 24 und 1:3 in Figur 25). Dies ist ein klarer Hinweis für das Vorliegen eines PhosphoreszenzÜberganges. Die Ergebnisse der Messungen an den einzelnen Proben sind in unten stehender Tabelle dargestellt.

| **PbTFA:BUPH1 Stoffmengenverhältnis** | **T1/ µs** |
|---|---|
| 1:1 | 2,61 |
| 1:2 | 9,58 |
| 1:3 | 52,56 |

Die Spektren wurden auf einer 20 µs Zeitskala gemessen, wobei die Phosphoreszenz-Lebensdauern der untersuchten Komposit-THF Lösungen sich im Bereich von 2,61 bis 52,56 Mikrosekunden bewegen.

## Patentansprüche

1. Verfahren zur Herstellung organisch elektrischer Schichten aufweisend in einem Temperaturbereich von -50°C bis 150°C phosphoreszente organische Emitter, **dadurch gekennzeichnet, dass** organisch fluoreszente Emitter F zusammen mit Metallkomplexen enthaltend organische Komplexliganden L und mindestens ein schweres Hauptgruppenmetall M ausgewählt aus der Gruppe umfassend In, Tl, Sn, Pb, Sb und Bi, gemeinsam innerhalb einer Schicht abgeschieden werden und das schwere Hauptgruppenmetall M seine Koordinationssphäre unter Aufnahme des organisch fluoreszenten Emitters F ändert.

2. Verfahren nach Anspruch 1, wobei das schwere Hauptgruppenmetall Bi umfasst.

3. Verfahren nach einem der vorhergehenden Ansprüche, wobei der Anteil der durch elektronische inter- und intra-Liganden-Übergänge hervorgerufenen, phosphoreszenten Emission unter rein elektronischer Anregung größer oder gleich 20% und kleiner oder gleich 100% beträgt.

4. Verfahren nach einem der vorhergehenden Ansprüche, wobei die organisch fluoreszenten Emitter F ausgewählt sind aus der Gruppe der substituierten oder nicht substituierten C6-C60 Aromaten oder Heteroaromaten.

5. Verfahren nach einem der vorhergehenden Ansprüche, wobei der organisch fluoreszente Emitter F 4,7-di(9H-carbazol-9-yl)-1,10-phenanthrolin (BUPH1)ist.

6. Verfahren nach einem der vorhergehenden Ansprüche, wobei die Liganden L des Metallkomplexes unabhängig voneinander ausgewählt sind aus der Gruppe umfassend Halogenide und fluorierte oder nicht-fluorierte C2-C20 Alkyl- oder Aryl-Carboxylate, -Alkoholate, -Thiolate, -Cyanate, -Isocyanate, - Thiocyanate, -Acetylacetonate, -Sulfonate.

7. Verfahren nach einem der vorhergehenden Ansprüche, wobei der Metallkomplex eine oder mehrere Verbindungen aus der Gruppe Bi(III)fluorobenzoat, Bi(III)fluoroalkylbenzoat, Bi(III)fluorodialkylbenzoat, Bi(III)fluorotrialkyl-benzoat, Bi(III)pentafluorobenzoat und Bi(III)3,5trifluormethyl-benzoat umfasst.

8. Verfahren nach einem der vorhergehenden Ansprüche, wobei der Metallkomplex eine oder mehrere Verbindungen aus der Gruppe der Trisarylbismuth(V)carboxylate umfasst.

9. Verfahren nach einem der Ansprüche 1 - 7, wobei der Metallkomplex ausgewählt ist aus der Gruppe umfassend Bi(III)triscarboxylat, Bi(III)fluoroacetat und Bi(III)trifluoroacetat.

10. Verfahren nach einem der vorhergehenden Ansprüche, wobei der Metallkomplex und der organisch fluoreszente Emitter F auf einem Trägersubstrat mittels Ko-Evaporation, Rotations-, Vorhangbeschichtung, Rakeln oder Drucken abgeschieden werden.

11. Verfahren nach Anspruch 10, wobei das molare Verhältnis von Metallkomplex zu organisch fluoreszenten Emitter F größer oder gleich 1:10 und kleiner oder gleich 10:1 beträgt.

12. Verfahren nach Anspruch 10 oder 11, wobei die Abscheidung des Metallkomplex und des organisch fluoreszenten Emitters F mittels eines Ko-Evaporationsverfahrens erfolgt und die Abscheiderate der organisch elektrischen Schicht größer oder gleich 0,1 Å/s und kleiner oder gleich 200 Å/s beträgt.

13. Schicht für ein organisch elektrisches Bauelement hergestellt nach einem Verfahren nach einem der Ansprüche 1 - 12.

14. Verwendung einer Schicht nach Anspruch 13 als aktive Schicht in einem organisch elektrischen Bauelement zur Umwandlung von elektrischem Strom in Licht, von Licht in elektrischen Strom und von Licht in Licht anderer Wellenlänge.

15. Organisches Halbleiterbauelement ausgewählt aus der Gruppe umfassend Photodioden, Solarzellen, organische Leuchtdioden, Licht emittierende elektrochemische Zellen enthaltend eine Schicht nach Anspruch 13.

## Claims

1. Process for producing organic electronic layers including organic emitters that are phosphorescent within a temperature range from -50°C to 150°C, **characterized in that** organic fluorescent emitters F are codeposited together with metal complexes containing organic complex ligands L and at least one heavy main group metal M selected from the group comprising In, Tl, Sn, Pb, Sb and Bi within one layer and the heavy main group metal M alters its coordination sphere with incorporation of the organic fluorescent emitter F.

2. Process according to Claim 1, wherein the heavy main group metal comprises Bi.

3. Process according to either of the preceding claims, wherein the proportion of phosphorescent emission caused by electronic inter- and intra-ligand transfers with purely electronic excitation is not less than 20% and not more than 100%.

4. Process according to any of the preceding claims, wherein the organic fluorescent emitters F are selected from the group of the substituted or unsubstituted C6-C60 aromatics or heteroaromatics.

5. Process according to any of the preceding claims, wherein the organic fluorescent emitter F is 4,7-di(9H-carbazol-9-yl)-1,10-phenanthroline (BUPH1).

6. Process according to any of the preceding claims, wherein the ligands L of the metal complex are independently selected from the group comprising halides and fluorinated or nonfluorinated C2-C20 alkyl or aryl carboxylates, alkoxides, thiolates, cyanates, isocyanates, thiocyanates, acetylacetonates, sulfonates.

7. Process according to any of the preceding claims, wherein the metal complex comprises one or more compounds from the group of Bi(III) fluorobenzoate, Bi(III) fluoroalkyl-benzoate, Bi(III) fluorodialkylbenzoate, Bi(III) fluorotri-alkylbenzoate, Bi(III) pentafluorobenzoate and Bi(III) 3,5-trifluoromethylbenzoate.

8. Process according to any of the preceding claims, wherein the metal complex comprises one or more compounds from the group of the triarylbismuth(V) carboxylates.

9. Process according to any of Claims 1-7, wherein the metal complex is selected from the group comprising Bi(III) triscarboxylate, Bi(III) fluoroacetate and Bi(III) trifluoroacetate.

10. Process according to any of the preceding claims, wherein the metal complex and the organic fluorescent emitter F are deposited on a carrier substrate by means of coevaporation, rotary or curtain coating, bar coating or printing.

11. Process according to Claim 10, wherein the molar ratio of metal complex to organic fluorescent emitter F is not less than 1:10 and not more than 10:1.

12. Process according to Claim 10 or 11, wherein the deposition of the metal complex and the organic fluorescent emitter F is effected by means of a coevaporation method and the deposition rate of the organic electronic layer is not less than 0.1 Å/s and not more than 200 Å/s.

13. Layer for an organic electronic component produced by a process according to any of Claims 1-12.

14. Use of a layer according to Claim 13 as an active layer in an organic electronic component for conversion of electrical current to light, of light to electrical current and of light to light of another wavelength.

15. Organic semiconductor component selected from the group comprising photodiodes, solar cells, organic light-emitting diodes, light-emitting electrochemical cells comprising a layer according to Claim 13.

## Revendications

1. Procédé de production de couches électriques de manière organique, comportant des émetteurs organiques phosphorescents dans une plage de température de -50°C à 150°C, **caractérisé en ce que** l'on dépose en commun au sein d'une couche des émetteurs F fluorescents de manière organique, ensemble avec des complexes métalliques contenant des ligands L complexes organiques et au moins un métal M lourd du groupe principal choisi dans le groupe comprenant In, T1, Sn, Pb, Sb et Bi, et **en ce que** le métal M lourd du groupe principal modifie sa sphère de coordination en absorbant l'émetteur F fluorescent de manière organique.

2. Procédé suivant la revendication 1, dans lequel le métal lourd du groupe principal comprend du Bi.

3. Procédé suivant l'une des revendications précédentes, dans lequel la proportion de l'émission phosphorescente provoquée par les transitions électroniques inter-ligants et intra-ligants, sous excitation électronique pure, est supérieure ou égale à 20% et inférieure ou égale à 100%.

4. Procédé suivant l'une des revendications précédentes, dans lequel les émetteurs F fluorescents de manière organique sont choisis dans le groupe des aromatiques ou hétéroaromatiques en C6 à C60, substitués ou non substitués.

5. Procédé suivant l'une des revendications précédentes, dans lequel l'émetteur fluorescent de manière organique est la 4,7-di (9H-carbazol-9-yl)-1,10-phénanthroline (BUPH1).

6. Procédé suivant l'une des revendications précédentes, dans lequel les ligands L du complexe mécanique sont choisis indépendamment les uns des autres dans le groupe comprenant des halogénures et des alcoyle ou aryle (en C2 à C20), carboxylate, alcoolate, thiolate, cyanate, isocyanate, thiocyanate, acétylacétonate, sulfonate fluorés et non fluorés.

7. Procédé suivant l'une des revendications précédentes, dans lequel le complexe métallique comprend un ou plusieurs composés choisis dans le groupe fluorobenzoate de Bi (III), fluoroalcoylbenzoate de Bi (III), fluorodialcoylbenzoate de Bi (III), fluorotrialcoylbenzoate de Bi (III), pentafluorobenzoate de Bi (III) et 3,5 trifluorométhylbenzoate de Bi (III).

8. Procédé suivant l'une des revendications précédentes, dans lequel le complexe métallique comprend un ou plusieurs composés choisis dans le groupe des carboxylates de trisarylbismuth (V).

9. Procédé suivant l'une des revendications 1 à 7, dans lequel le complexe métallique est choisi dans le groupe comprenant le triscarboxylate de Bi (III), le fluoroacétate de Bi (III) et le trifluoroacétate de Bi (III).

10. Procédé suivant l'une des revendications précédentes, dans lequel on dépose le complexe métallique et l'émetteur F fluorescent de manière organique sur un substrat support, au moyen d'une co-évaporation, d'un revêtement par rotation, d'un revêtement au rideau, à la racle ou par impression.

11. Procédé suivant la revendication 10, dans lequel le rapport molaire du complexe métallique à l'émetteur F fluorescent de manière organique est supérieur ou égal à 1:10 et inférieur ou égal à 10:1.

12. Procédé suivant la revendication 10 ou 11, dans lequel le dépôt du complexe mécanique et de l'émetteur F fluorescent de manière organique s'effectue au moyen d'un procédé de co-évaporation et la vitesse au dépôt de la couche électrique de manière organique est supérieure ou égale à 0,1 Å/s et inférieure ou égale à 200 Å/s.

13. Couche pour un composant électrique de manière organique produite par un procédé suivant l'une des revendications 1 à 12.

14. Utilisation d'une couche suivant la revendication 13, comme couche active dans un composant électrique de manière organique pour transformer du courant électrique en lumière, de la lumière en courant électrique et de la lumière en de la lumière d'une autre longueur d'onde.

15. Composant organique à semi-conducteur choisi dans le groupe comprenant des photodiodes, des piles solaires, des diodes organiques électroluminescentes, des piles électrochimiques émettant de la lumière comportant une couche suivant la revendication 13.
